# EUROPEAN PATENT SPECIFICATION

(11) **EP 4 106 235 B1**
(45) Date of publication and mention of the grant of the patent: **12.08.2026**
(21) Application number: 20918299.7
(22) Date of filing: 23.09.2020
(51) Int. Cl.: H04L 1/00, H04L 27/26, H03M 13/35

(54) **OFDM-BASED HIGH-SPEED WIRELESS COMMUNICATION PHYSICAL LAYER TRANSMISSION SIGNAL GENERATION METHOD AND SYSTEM**
VERFAHREN UND SYSTEM ZUR ERZEUGUNG VON PHYSICAL-LAYER-ÜBERTRAGUNGSSIGNALEN IN DER HOCHGESCHWINDIGKEITSDRAHTLOSKOMMUNIKATION AUF OFDM-BASIS
PROCÉDÉ ET SYSTÈME DE GÉNÉRATION DE SIGNAL DE TRANSMISSION DE COUCHE PHYSIQUE DE COMMUNICATION SANS FIL À GRANDE VITESSE FONDÉ SUR UN MROF

(30) Priority: 14.02.2020 CN 202010092345
(43) Date of publication of application: 21.12.2022
(73) Proprietor: China Electric Power Research Institute Company Limited, Beijing 100192 (CN); State Grid Corporation of China, Beijing 100031 (CN)
(72) Inventor: LIU, Xuan, Beijing 100192 (CN); ZHANG, Hailong, Beijing 100192 (CN); TANG, Yue, Beijing 100192 (CN); LI, Ran, Beijing 100192 (CN); REN, Yi, Beijing 100192 (CN); DU, Xingang, Beijing 100192 (CN); LIN, Fantao, Beijing 100192 (CN)
(74) Representative: Kraus & Lederer PartGmbB
(86) International application number: PCT/CN2020/117126
(87) International publication number: WO 2021/159709

(56) References cited:
- CN-A- 105 591 826
- CN-A- 106 603 457
- CN-A- 106 685 766
- CN-A- 111 327 400
- CN-U- 205 490 603
- GB-A- 2 562 375
- US-A1- 2016 127 515
- US-A1- 2017 265 129

## Description

### TECHNICAL FIELD

The present application relates to the technical field of wireless communication, for example, an OFDM-based high-speed wireless communication physical layer transmission signal generation method and system.

### BACKGROUND

Power-line carrier communication is the wired communication technology for transmitting and receiving communication signals by power lines and is an important electricity information acquisition communication technology commonly used before in power grids. As the planning and schemes for developing smart grids in China are proposed and the construction of an electricity information system advances continuously, the number of smart meters and the number of acquisition terminals increase greatly and power electronic devices and frequency conversion equipment are widely applied. Therefore, the electromagnetic environment of a power grid is increasingly complex, resulting in a worse carrier communication environment and instable communication performance between a smart meter and an acquisition terminal.

In view of the above interference and attenuation of power lines, micro-power wireless technology emerged. Wireless communication effectively prevents the interference and attenuation on power lines and strongly ensures the real-time performance of communication due to a relatively high communication rate. However, the wireless communication is easily interfered with an environment, and a signal attenuates greatly when penetrating walls and buildings. An electricity information acquisition system must ensure the reliability and stability of data transmissions in an information acquisition process. The power-line carrier communication and the wireless communication have respective advantages and disadvantages and it is more significant in practice to combine the power-line carrier communication and the wireless communication to make use of their advantages. Therefore, a dual-mode communication system becomes a popular trend and OFDM-based high-speed wireless communication in the dual-mode communication system becomes a hot research field at present.

Orthogonal frequency-division multiplexing (OFDM) technology is to convert a set of serial data streams transmitted at a high speed into low-speed parallel data streams and modulate these parallel data streams on mutually orthogonal subcarriers, achieving parallel data transmissions. The OFDM technology has the advantages of relatively strong capabilities to resist intersymbol interference, fading, and burst noise and a relatively high spectrum utilization rate. According to the characteristics of power wireless channels, the OFDM technology can be used in power wireless communication to resist the facing of wireless channels and various noise and interference introduced, so as to meet the requirements of smart grids for reliability, security, timeliness, and the like.

UK patent application 2562375 A discloses a signal processing method, comprising: receiving data from a link layer, and dividing the data into frame control data and payload data; performing channel encoding on the frame control data and the payload data, respectively, and modulating the channel encoded frame control data and payload data onto a subcarrier; performing an inverse Fourier transform operation on the modulated frame control data and payload data, and respectively performing power control to generate a time-domain frame control symbol and a time-domain payload symbol; and adding cyclic prefixes to the time-domain frame control symbol and the time-domain payload symbol, adding time-domain preamble symbols, and performing windowing processing to generate a physical layer transmission signal.

US patent application 2017/0265129 A1 discloses an access point (AP), station (STA) and method for subcarrier scaling are generally described herein. The AP may transmit a high efficiency (HE) physical layer convergence procedure (PLCP) protocol data unit (PPDU) that includes a legacy long training field (L-LTF), a legacy signal (L-SIG) field, and an HE signal (HE-SIG) field. The HE-SIG may be based on HE-SIG symbols mapped to a group of HE subcarriers that includes legacy subcarriers and HE extension subcarriers. The L-LTF may be based on L-LTF pilot symbols mapped to the legacy subcarriers. The L-SIG may be based on L-SIG legacy symbols mapped to the legacy subcarriers and L-SIG extension pilot symbols mapped to the HE extension subcarriers. The AP may scale a per-subcarrier power of the L-SIG extension pilot symbols to match a per-subcarrier power of the L-LTF pilot symbols.

### SUMMARY

The present application provides an OFDM-based high-speed wireless communication physical layer transmission signal generation method and system, so as to improve frequency band efficiency and a capability to resist channel multipath fading of high-speed wireless communication.

In a first aspect, the present application provides an OFDM-based high-speed wireless communication physical layer transmission signal generation method which includes the steps described below.

Output data is received from a medium access control (MAC) layer, physical-layer header (PHR) data is determined according to a modulation and coding scheme of physical-layer service data unit (PSDU) data in the output data, and signal fields (SIG) data is determined according to a modulation and coding scheme of the PHR data.

Each of the SIG data, the PHR data, and the PSDU data is processed in a respective preset processing manner so as to acquire the processed SIG data, the processed PHR data, and the processed PSDU data.

A constellation mapping is performed on each of the processed SIG data, the processed PHR data, and the processed PSDU data in a preset mapping manner, power-controlled pilot data is inserted to the each of the processed SIG data, the processed PHR data, and the processed PSDU data, and an inverse Fourier transform is performed on the SIG data inserted with the pilot data, the PHR data inserted with the pilot data, and the PSDU data inserted with the pilot data for conversion into time domain.

A cyclic prefix is added to each of the SIG data converted into the time domain, the PHR data converted into the time domain, and the PSDU data converted into the time domain so as to generate OFDM symbols corresponding to the SIG data, OFDM symbols corresponding to the PHR data, and OFDM symbols corresponding to the PSDU data, respectively.

An inverse Fourier transform and power control are performed on preamble signal data generated in frequency domain so as to acquire time domain preamble signal data.

The time domain preamble signal data, the OFDM symbols corresponding to the SIG data, the OFDM symbols corresponding to the PHR data, and the OFDM symbols corresponding to the PSDU data are windowed so as to generate an OFDM-based frame signal which enters an analog front end.

The pilot data is generated from a pseudo-noise, PN, sequence with all initial values being 1; a first output bit of the PN sequence is placed on a pilot subcarrier corresponding to Pilot Tone #1 in set 1, subsequent bits are placed on corresponding pilot subcarriers in sequence, and pilot subcarriers uniformly use a binary phase-shift keying, BPSK, modulation manner.

The OFDM symbols have three options, wherein a fast Fourier transform, FFT, in option 1 has 128 points, an FFT in option 2 has 64 points, an FFT in option 3 has 32 point, and after a long training field, LTF, frame, each OFDM symbol on an SIG data frame to a PSDU data frame uses one pilot set in sequence;
The OFDM-based frame signal includes the preamble signal data, the SIG data, the PHR data, and the PSDU data, wherein the preamble signal data includes short training field, STF, data and LTF data.

The STF data is obtained by a dot product of sequences in a basic layer and a scrambling code layer, the scrambling code layer is composed of a 10-bit sequence, a sequence in the scrambling code layer is [-1 -1 -1 -1 1 1 -1 -1 -1 1] regardless of OFDM options, an STF sequence has four STF OFDM symbols, and a length of a cyclic prefix added before each OFDM symbol is 1/4 a length of the OFDM symbol, wherein in option 1, there are 8 sets of repeated data within each symbol with an FFT length, in option 2, there are 4 sets of repeated data within each symbol with an FFT length, and in option 3, there are 2 sets of repeated data within each symbol with an FFT length.

The step in which each of the SIG data, the PHR data, and the PSDU data is processed in a respective preset processing manners to acquire the processed SIG data, the processed PHR data, and the processed PSDU data includes: performing (36, 3) block coding, symbol filling, and scrambling on the SIG data in sequence to acquire the processed SIG data; performing Turbo coding, channel interleaving, and diversity copying on the PHR data in sequence to acquire the processed PHR data, wherein the diversity copying is used for diversity and the mapping on the PHR data; and performing scrambling, Turbo coding, channel interleaving, and diversity copying on the PSDU data in sequence to acquire the processed PSDU data, wherein the diversity copying is used for diversity and the mapping on the PSDU data.

In a second aspect, the present application provides an OFDM-based high-speed wireless communication physical layer transmission signal generation system which includes a data receiving unit, a data processing unit, a data conversion unit, an OFDM symbol generation unit, a preamble signal data acquisition unit, and an OFDM-based frame signal generation unit.

The data receiving unit is configured to receive output data from a medium access control (MAC) layer, determine physical-layer header (PHR) data according to a modulation and coding scheme of physical-layer service data unit (PSDU) data in the output data, and determine signal fields (SIG) data according to a modulation and coding scheme of the PHR data.

The data processing unit is configured to process each of the SIG data, the PHR data, and the PSDU data in a respective preset processing manner to acquire the processed SIG data, the processed PHR data, and the processed PSDU data.

The data conversion unit is configured to perform a constellation mapping on each of the processed SIG data, the processed PHR data, and the processed PSDU data in a preset mapping manner, insert power-controlled pilot data to each of the processed SIG data, the processed PHR data, and the processed PSDU data, and perform an inverse Fourier transform on the SIG data inserted with the pilot data, the PHR data inserted with the pilot data, and the PSDU data inserted with the pilot data for conversion into time domain.

The OFDM symbol generation unit is configured to add a cyclic prefix to each of the SIG data converted into the time domain, the PHR data converted into the time domain, and the PSDU data converted into the time domain to generate OFDM symbols corresponding to the SIG data, OFDM symbols corresponding to the PHR data, and OFDM symbols corresponding to the PSDU data, respectively.

The preamble signal data acquisition unit is configured to perform an inverse Fourier transform and power control on preamble signal data generated in frequency domain to acquire time domain preamble signal data.

The OFDM-based frame signal generation unit is configured to window the time domain preamble signal data, the OFDM symbols corresponding to the SIG data, the OFDM symbols corresponding to the PHR data, and the OFDM symbols corresponding to the PSDU data to generate an OFDM-based frame signal which enters an analog front end.

The pilot data is generated from a pseudo-noise, PN, sequence with all initial values being 1; a first output bit of the PN sequence is placed on a pilot subcarrier corresponding to Pilot Tone #1 in set 1, subsequent bits are placed on corresponding pilot subcarriers in sequence, and pilot subcarriers uniformly use a binary phase-shift keying, BPSK, modulation manner.

The OFDM symbols have three options, wherein a fast Fourier transform, FFT, in option 1 has 128 points, an FFT in option 2 has 64 points, an FFT in option 3 has 32 point, and after a long training field, LTF, frame, each OFDM symbol on an SIG data frame to a PSDU data frame uses one pilot set in sequence;

The OFDM-based frame signal includes the preamble signal data, the SIG data, the PHR data, and the PSDU data, wherein the preamble signal data includes short training field, STF, data and LTF data.

The STF data is obtained by a dot product of sequences in a basic layer and a scrambling code layer, the scrambling code layer is composed of a 10-bit sequence, a sequence in the scrambling code layer is [-1 -1 -1 -1 1 1 -1 -1 -1 1] regardless of OFDM options, an STF sequence has four STF OFDM symbols, and a length of a cyclic prefix added before each OFDM symbol is 1/4 a length of the OFDM symbol, wherein in option 1, there are 8 sets of repeated data within each symbol with an FFT length, in option 2, there are 4 sets of repeated data within each symbol with an FFT length, and in option 3, there are 2 sets of repeated data within each symbol with an FFT length.

The data processing unit is configured to process each of the SIG data, the PHR data, and the PSDU data in the respective preset processing manner to acquire the processed SIG data, the processed PHR data, and the processed PSDU data, and the data processing unit includes an SIG data processing module, a PHR data processing module, and a PSDU data processing module; wherein the SIG data processing module is configured to perform (36, 3) block coding, symbol filling, and scrambling on the SIG data in sequence to acquire the processed SIG data.

The PHR data processing module is configured to perform Turbo coding, channel interleaving, and diversity copying on the PHR data in sequence to acquire the processed PHR data; and The PSDU data processing module is configured to perform scrambling, Turbo coding, channel interleaving, and diversity copying on the PSDU data in sequence to acquire the processed PSDU data, where the diversity copying is used for diversity and the mapping on each of the PHR data and the PSDU data.

### BRIEF DESCRIPTION OF DRAWINGS

FIG. 1 is a flowchart of an OFDM-based high-speed wireless communication physical layer transmission signal generation method 100 according to an embodiment of the present application.
FIG. 2 is a schematic diagram of processing on SIG data according to an embodiment of the present application.
FIG. 3 is a diagram of a matrix generated after (36, 3) block coding is performed on SIG data according to an embodiment of the present application.
FIG. 4 is a schematic diagram of scrambling on data according to an embodiment of the present application.
FIG. 5 is a schematic diagram of processing on PHR data according to an embodiment of the present application.
FIG. 6 is a schematic diagram of processing on PSDU data according to an embodiment of the present application.
FIG. 7 is a structural diagram of a Turbo encoder according to an embodiment of the present application.
FIG. 8 is a structural diagram of a Turbo component encoder according to an embodiment of the present application.
FIG. 9 is a diagram of a format of a time domain frame in an STF basic layer according to an embodiment of the present application.
FIG. 10 is a diagram of a format of an STF frame according to an embodiment of the present application.
FIG. 11 is a diagram of a format of an LTF frame according to an embodiment of the present application.
FIG. 12 is a time domain graph of modules of power-controlled STF and LTF of a preamble sequence at a bandwidth of 200 kHz according to an embodiment of the present application.
FIG. 13 is a graph of an autocorrelation characteristic of LFT in a preamble sequence at a bandwidth of 200 kHz according to an embodiment of the present application.
FIG. 14 is a time domain graph of an SIG module generated using a data phase mapping table at a bandwidth of 200 kHz according to an embodiment of the present application.
FIG. 15 is a time domain graph of a PHR frame module generated using a data phase mapping table at a bandwidth of 200 kHz according to an embodiment of the present application.
FIG. 16 is a structural diagram of a frame signal according to an embodiment of the present application.
FIG. 17 is a schematic diagram of the generation of a frame signal according to an embodiment of the present application.
FIG. 18 is a structural diagram of an OFDM-based high-speed wireless communication physical layer transmission signal generation system 1800 according to an embodiment of the present application.

### DETAILED DESCRIPTION

Example embodiments of the present application are described with reference to drawings. However, the present application may be implemented in many different forms and is not limited to the embodiments described herein. These embodiments are provided to disclose the present application in detail and completely and fully convey the scope of the present application to those skilled in the art. The terms in the example embodiments illustrated in the drawings are not to limit the present application. In the drawings, the same units/elements use the same reference numerals.

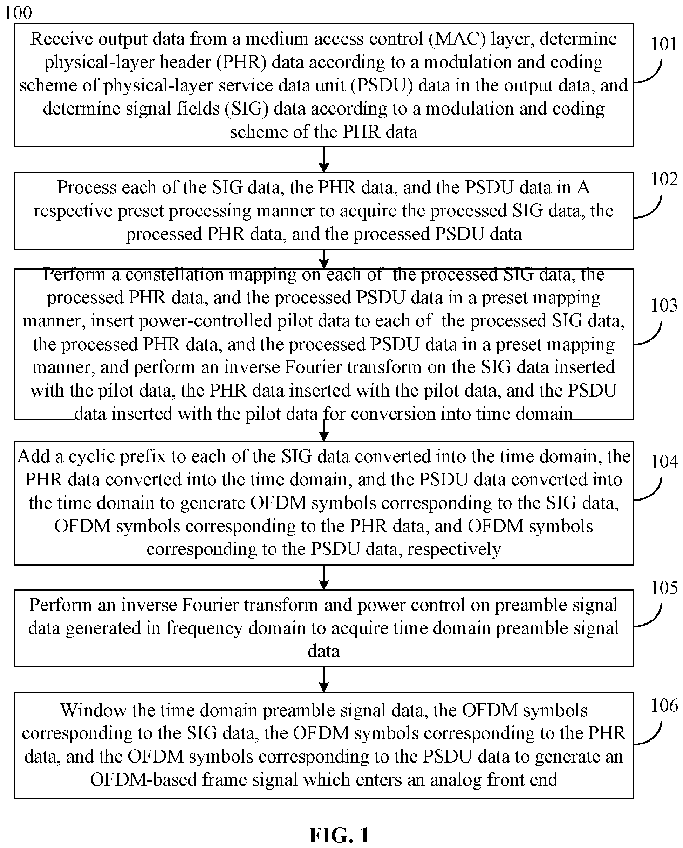

Unless otherwise specified, terms (including scientific and technical terms) used herein have the same meanings as those commonly understood by those skilled in the art. Additionally, it is to be understood that the terms defined in the commonly used dictionaries have meanings consistent with their meaning in the context of the relevant art and should not be interpreted in an idealized or overly formal sense
FIG. 1 is a flowchart of an OFDM-based high-speed wireless communication physical layer transmission signal generation method 100 according to an embodiment of the present application. As shown in FIG. 1, the OFDM-based high-speed wireless communication physical layer transmission signal generation method provided in the embodiment of the present application improves frequency band efficiency and a capability to resist channel multipath fading of high-speed wireless communication by using OFDM technology; meanwhile, error rates of signal fields (SIG) data, physical-layer header (PHR) data, and physical-layer service data unit (PSDU) data are reduced by techniques such as Turbo coding, channel interleaving, and diversity copying, improving the robustness of a system; a phase rotation factor is added during a constellation mapping, reducing a peak-to-average ratio of OFDM symbols and improving power amplification efficiency of the system; and based on the OFDM technology, the requirements of smart grids for reliability, security, timeliness, and the like can be met. The OFDM-based high-speed wireless communication physical layer transmission signal generation method 100 provided in the embodiment of the present application includes step 101 to step 106. In step 101, output data is received from a medium access control (MAC) layer, PHR data is determined according to a modulation and coding scheme of PSDU data in the output data, and SIG data is determined according to a modulation and coding scheme of the PHR data.

In the embodiment of the present application, a physical layer receives input from the MAC layer, divides the data from the MAC layer into the SIG data, the PHR data, and the PSDU data, and separately processes the coding of the SIG data, the PHR data, and the PSDU data. Physical layer OFDM symbols in the embodiment of the present application have three options, where a fast Fourier transform (FFT) in option 1 has 128 points, an FFT in option 2 has 64 points, an FFT in option 3 has 32 point, and a symbol length is 122.88 ms in all the three OFDM options. Parameters such as a communication bandwidth, the number of FFT points, and an effective carrier in three communication options of the physical layer are shown in Table 1. Within a used communication frequency band of 470 MHz to 510MHz, the details of the options are shown in Table 2. The number of time domain points of OFDM symbols used is shown in Table 3. The modulation and coding scheme of signal fields (SIG) and the number of symbols used are shown in Table 4.

**Table 1 Communication options and bandwidths**

| Parameter | Option 1 | Option 2 | Option 3 |
|---|---|---|---|
| Nominal bandwidth (kHz) | 854.5 | 431.3 | 170.9 |
| Channel spacing (kHz) | 1000 | 500 | 200 |
| FFT size | 128 | 64 | 32 |
| Active tones | 104 | 52 | 20 |
| #Pilot tones | 8 | 4 | 2 |
| #Data tones | 96 | 48 | 18 |

**Table 2 Communication frequency band, number of channels, and first channel center frequency**

| Frequency Band/MHz | Total Bandw idth/M Hz | Modulation Manner | Channel Spacing/M Hz | Channel Center Frequency/M Hz |
|---|---|---|---|---|
| | | OFDM Option3 | 0.2 | 470.4 |
| 470-510 | 40 | OFDM Option2 | 0.5 | 470.8 |
| | | OFDM Option1 | 1.0 | 471.2 |

**Table 3 OFDM symbol characteristics**

| Symbol Parameter | Option 1 | | Option 2 | | Option 3 | |
|---|---|---|---|---|---|---|
| | Number of Time Domain Points | Time (us) | Number of Time Domain Points | Time (us) | Number of Time Domain Points | Time (us) |
| Preamble IFFT length | 128 | 122.88 | 64 | 122.88 | 32 | 122.88 |
| SIG/PHR/PSD U data IFFT length | 128 | 122.88 | 64 | 122.88 | 32 | 122.88 |
| Roll-off interval | 8 | 7.68 | 4 | 7.68 | 4 | 15.36 |
| Guard Period | 32 | 30.72 | 16 | 30.72 | 8 | 30.72 |
| Cyclic prefix | 40 | 38.4 | 20 | 38.4 | 12 | 46.08 |

**Table 4 SIG modulation and coding scheme**

| | Option1 | Option2 | Option3 |
|---|---|---|---|
| Number of carriers for data | 96 | 48 | 18 |
| Modulation and coding scheme of SIG | (36, 3), BPSK | (36, 3), BPSK | (36, 3), BPSK |
| Number of symbols for SIG | 1 | 2 | 2 |

In step 102, each of the SIG data, the PHR data, and the PSDU data is processed in a respective preset processing manner so that the processed SIG data, the processed PHR data, and the processed PSDU data are acquired.

In an embodiment, the step in which each of the SIG data, the PHR data, and the PSDU data is processed in the respective preset processing manner so that the processed SIG data, the processed PHR data, and the processed PSDU data are acquired includes the steps described below.

(36, 3) block coding, symbol filling, and scrambling are performed on the SIG data in sequence so that the processed SIG data is acquired.

Turbo coding, channel interleaving, and diversity copying are performed on the PHR data in sequence so that the processed PHR data is acquired.

Scrambling, Turbo coding, channel interleaving, and diversity copying are performed on the PSDU data in sequence so that the processed PSDU data is acquired.

In an embodiment, the Turbo coding is performed on the PHR data and the PSDU data separately by using a Turbo encoder, where the Turbo encoder includes a Turbo interleaver, a first component encoder, and a second component encoder; the PHR data and the PSDU data are each used as an input signal of the first component encoder and an input signal of the Turbo interleaver, and an output signal of the Turbo interleaver is used as an input signal of the second component encoder; the Turbo interleaver interleaves the PHR data in units of double bits, where an interleaving length is equal to the number of double bits included in a block length of the PHR data, and the Turbo interleaver interleaves the PSDU data in units of double bits, where an interleaving length is equal to the number of double bits included in a block length of the PSDU data; and the Turbo interleaver selects different code rates according to different requirements.

In an embodiment, when the Turbo coding is performed on the PHR data, a Turbo code block has a length of physical block 16 (PB16) and supports a code rate of 1/2 and a code rate of 4/5.

The PSDU data supports six modes, which are PB16, PB40, PB72, PB136, PB264, and PB520, each mode supports a code rate of 1/2 and a code rate of 4/5, and when the Turbo coding is performed on the PSDU data, different code block lengths and different code rates are selected according to different requirements.

In an embodiment, when the channel interleaving is performed on Turbo coded PHR data and Turbo coded PSDU data, each of the Turbo coded PHR data and the Turbo coded PSDU data is divided into information codes and check codes which are interleaved separately; where when the information codes are interleaved, information bits of the information codes are input in columns and output in rows, and different rows are read such that the information codes are disarranged; and the check codes are interleaved in the same manner as interleaving the information codes except that the check codes are read from an offset address.

Interleaved information codes and interleaved check codes are interleaved in a manner determined according to a code rate that is calculated according to the information codes and the check codes.

In an embodiment, the diversity copying includes diversity and mapping on each of the PHR data and the PSDU data.

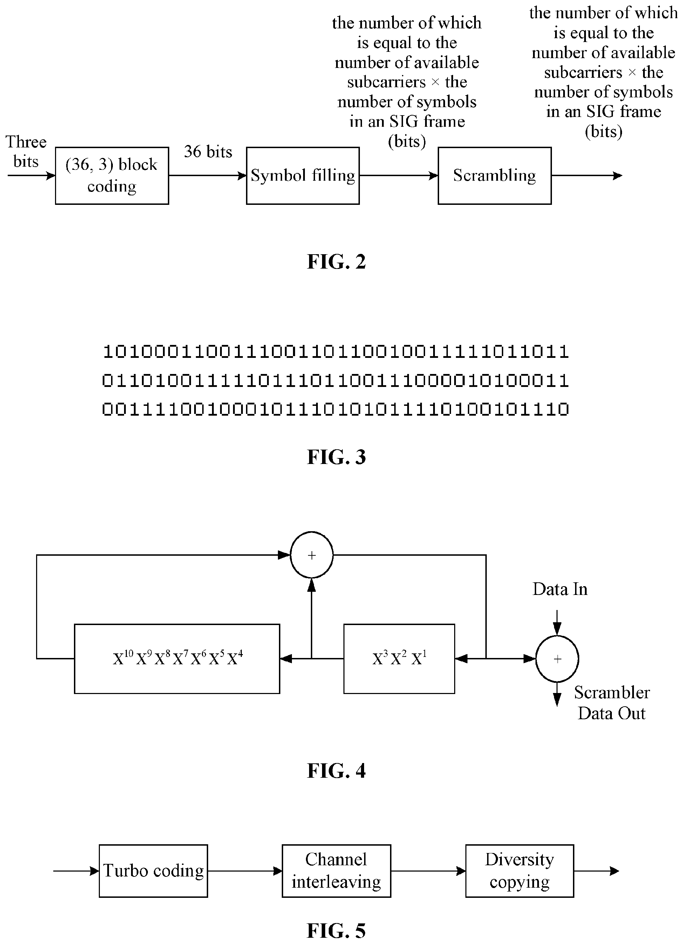

FIG. 2 is a schematic diagram of processing on SIG data according to an embodiment of the present application. As shown in FIG. 2, the (36, 3) block coding, the symbol filling, and the scrambling are performed on the SIG data. Firstly, the (36, 3) block coding is performed on the SIG data, and a matrix generated after the (36, 3) block coding is performed on the SIG data is shown in FIG. 3. Then, the symbol filling is performed on the outputted 36 bits. After the SIG are encoded to obtain the 36 bits, the 36 bits after coding are directly repeated in each option until all OFDM symbols are filled. Finally, bits after the symbol filling are scrambled. The bits after the coding and the symbol filling on the SIG need to be scrambled. A scrambling method is the same as a PSDU scrambling method, and an initial seed is all 1. A scrambling manner is to perform an exclusive or operation on a data stream and a repetitive pseudo-random noise sequence. A scrambling polynomial of a pseudo-random noise sequence is generated from a primitive polynomial. FIG. 4 is a schematic diagram of scrambling on data according to an embodiment of the present application. As shown in FIG. 4, the scrambling polynomial is *S*(*x*) = *x*¹⁰ + *x*³ + 1. The above equation represents that each time one datum is input, the scrambling polynomial is shifted left by one bit, the exclusive or operation is performed on a third bit and a tenth bit of the scrambling polynomial, and the exclusive or operation is performed again on an outputted result and the inputted datum so that output data can be obtained.

FIG. 5 is a schematic diagram of processing on PHR data according to an embodiment of the present application. As shown in FIG. 5, the Turbo coding, the channel interleaving, and the diversity copying are performed on the PHR data in sequence.

Firstly, the Turbo coding is performed on the PHR data, where the Turbo code block of PHR has a length of PB16 and supports a code rate of 1/2 and a code rate of 4/5. First 128 bits are information codes, followed by check codes. For a coding flow, reference is made to the coding flow of the PSDU data.

Then, the channel interleaving is performed on outputted bits. A channel interleaving unit of the PHR is configured to randomize information bits and check bits outputted from the Turbo encoder before they are copied multiple times and transmitted to a channel.

When the information bits are interleaved, the information bits are divided into four sub-blocks, where each sub-block has a size of K/4 bits. The information bits are written in columns into a matrix with K/4 rows and 4 columns and read out in rows. In a first round, (0, StepSize, 2×StepSize, ...) rows are read to an end of the matrix; in a second round, (1, 1+StepSize, 1+2×StepSize, ...) rows are read to the end of the matrix; and all rows are read after StepSize rounds. When the check bits are interleaved, the check bits are divided into four sub-blocks, where each sub-block has a size of T = (N - k)/4 bits. The check bits are written in columns into a matrix with T rows and 4 columns and read out in rows. In a first round, (offset, offset+StepSize, offset+2×StepSize, ...) mod T rows are read; in a second round, (offset+1, offset+1+StepSize, offset+1+2×StepSize, ...) mod T rows are read, T/StepSize rows are read in each round, and all the T rows are read after StepSize rounds. The number of the information bits is K, the number of coded bits is N, and the number of the check bits is (N-K).

Finally, the diversity copying is performed on interleaved bits. The diversity copying is used for the diversity and the mapping on an original signal. The diversity copying can be omitted only when the number of diversity times is 1. The diversity copying processes original data according to a diversity copying process of the PSDU data and according to a different number of copying times in a selected option. If InData(i) represents bits outputted from a channel interleaver, a bit sequence OutData(i) outputted after the diversity copying is derived below. $x = \left⌊a\right⌋$ represents that a value of x is a maximum integer less than or equal to a, that is, a floor operation.

In each diversity, a group that is not filled ultimately is filled with PadBitsNum bits. Example data is as follows: data in a first diversity is bit 0 to bit (PadBitsNum-1) from the original data, data in a second diversity is bit PadBitsNum to bit (2×PadBitsNum-1) from the original data, and the same is done until an N-th diversity is obtained.

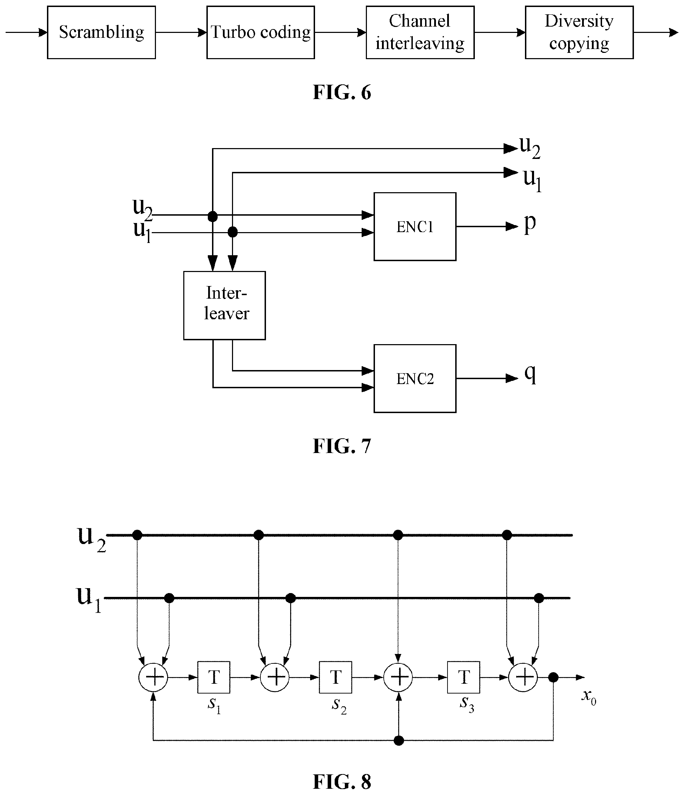

FIG. 6 is a schematic diagram of processing on PSDU data according to an embodiment of the present application. As shown in FIG. 6, in the embodiment of the present application, the scrambling, the Turbo coding, the channel interleaving, and the diversity copying are performed on the PSDU data in sequence. When the Turbo coding is performed on scrambled PSDU data, the PSDU data supports six modes, PB16, PB40, PB72, PB136, PB264, and PB520, and each mode supports a code rate of 1/2 and a code rate of 4/5 and supports only one PB. A Turbo coding process includes component coding, bit interleaving, and puncturing.

In the embodiment of the present application, coding is performed by using the structure of the Turbo encoder shown in FIG. 7, where the Turbo encoder consists of two identical component encoder (ENC1, ENC2), and each time a pair of information bits (*u*₁, *u*₂) is inputted, system bits (*u*₁, *u*₂) and check bits (*p, q*) are outputted. ENC1 and ENC2 each use an 8-state encoder, a first bit of an inputted data stream is mapped to *u*₁ and a second bit of the inputted data stream is mapped to *u*₂, and so on. In one encoder (ENC), each pair of bits corresponds to the output of one check bit. After the Turbo coding, the inputted [u1, u2] are coded into [u1, u2, p, q]. A state of a register in a component encoder of the Turbo encoder is related to a tail-biting matrix that is determined by a size of a physical block (PB) and a generator polynomial of the component encoder. The component encoder can use different generator polynomials according to different code block lengths.

The Turbo interleaver interleaves the original data as the input of the second component encoder. The Turbo interleaver performs interleaving in units of double bits, where the interleaving length is equal to the number of double bits included in a block length of the original data. The PSDU data is interleaved through a certain address mapping relationship.

FIG. 8 is an example embodiment of the component encoder whose flow is described below.

In step 1, an initial state of the register is set to *S*0=[*S*₀₁,*S*₀₂,*S*₀₃], which is [0,0,0].

In step 2, the information bits are inputted to the component encoder (the interleaved information bits are inputted to ENC2) until a last bit is inputted, so as to obtain a final state *SN*=[*S*_{*N*1,}*S*_{*N*2},*S*_{*N*3}] at the end of the coding.

In step 3, a matrix M is defined.

When PB_Size is 520, 72, or 16, $M = \left[\begin{matrix}0 & 0 & 1 \\ 1 & 0 & 1 \\ 1 & 1 & 1\end{matrix}\right] .$

When PB_Size is 264 or 40, $M = \left[\begin{matrix}1 & 0 & 1 \\ 1 & 1 & 1 \\ 1 & 1 & 0\end{matrix}\right] .$

When PB_Size is 136, $M = \left[\begin{matrix}0 & 1 & 1 \\ 1 & 0 & 0 \\ 0 & 1 & 0\end{matrix}\right] .$

*S*0'=*SN*×*M*, (where SN denotes a row vector and a look-up table is used for the above calculation in practice).

In step 4, the information bits are re-inputted to the component encoder whose initial state is calculated from step 3, and the final state of the component encoder is *N*'=*S*0' after the coding is performed again so that the check bits of the Turbo coding can be outputted.

The Turbo interleaver is configured to interleave the original data as the input of the second component encoder. Turbo interleaving is performed in units of double bits, where a length of the interleaver is equal to the number of double bits included in the block length of the original data. Parameters of the Turbo interleaving are as defined in Table 5, different parameters are used for different PB lengths, and there are six PB lengths: PB16, PB40, PB72, PB136, PB264, and PB520.

**Table 5 Parameters of the Turbo interleaving**

| PB (Number of Bytes) | Length of an S Table | Double-Bit Interleaving Length/Length of the S Table | Double-Bit Interleaving Length |
|---|---|---|---|
| 16 | 8 | 8 | 64 |
| 40 | 8 | 20 | 160 |
| 72 | 18 | 16 | 288 |
| 136 | 34 | 16 | 544 |
| 264 | 33 | 32 | 1056 |
| 520 | 40 | 52 | 2080 |

Firstly, it is specified that an address mapping *I*(*x*) of the Turbo interleaving is defined as follows: $I \left(x\right) = \left[S\left(x mod N\right)-\left(x div N\right)*N+L\right] mod L for x = 0 , 1 , … , L - 1 .$

S() denotes a look-up table, N denotes the length of the S table, M denotes the double-bit interleaving length divided by the length of the S table, x denotes an unknown address and its value is within a range of 0, 1, ..., L-1, L denotes the double-bit interleaving length, see Table 6 to Table 11, div denotes an integer division, and mod denotes a modulo operation. The address mapping *I*(*x*) is used for the Turbo interleaving according to the following algorithm: $\left.\begin{matrix}if x mod 2 = = 0 & \\ & \begin{matrix}IntData \left(2⋅x\right) & = Data \left(2⋅I\left(x\right)+1\right) \\ IntData \left(2⋅x+1\right) & = Data \left(2⋅I\left(x\right)\right)\end{matrix} \\ if x mod 2 = = 1 & \\ & \begin{matrix}IntData \left(2⋅x\right) & = Data \left(2⋅I\left(x\right)\right) \\ IntData \left(2⋅x+1\right) & = Data \left(2⋅I\left(x\right)+1\right)\end{matrix}\end{matrix}\right\} for x = 0 , 1 , 2 , … , L - 1 .$

*D*ata() denotes the input of the interleaver and *IntD*ata() denotes the output of the interleaver. It is to be noted that when an output address of the interleaver is an even number, bit 0 and bit 1 in the corresponding interleaved pair of information bits need to be exchanged.

**Table 6 S look-up table for PB16**

| | | | | | | | | |
|---|---|---|---|---|---|---|---|---|
| x | 0 | 1 | 2 | 3 | 4 | 5 | 6 | 7 |
| S(x) | 53 | 20 | 9 | 32 | 62 | 39 | 51 | 18 |

**Table 7 S look-up table for PB40**

| | | | | |
|---|---|---|---|---|
| x | 0 | 1 | 2 | 3 |
| S(x) | 156 | 65 | 138 | 47 |
| x | 4 | 5 | 6 | 7 |
| S(x) | 86 | 13 | 99 | 112 |

**Table 8 S look-up table for PB72**

| | | | | | | | | |
|---|---|---|---|---|---|---|---|---|
| x | 0 | 1 | 2 | 3 | 4 | 5 | 6 | 7 |
| S(x) | 1 | 200 | 255 | 166 | 221 | 132 | 187 | 98 |
| x | 8 | 9 | 10 | 11 | 12 | 13 | 14 | 15 |
| S(x) | 153 | 64 | 119 | 30 | 85 | 284 | 51 | 250 |
| x | 16 | 17 | | | | | | |
| S(x) | 17 | 216 | | | | | | |

**Table 9 S look-up table for PB136**

| | | | | | | | | |
|---|---|---|---|---|---|---|---|---|
| x | 0 | 1 | 2 | 3 | 4 | 5 | 6 | 7 |
| S(x) | 383 | 68 | 262 | 180 | 484 | 363 | 302 | 152 |
| x | 8 | 9 | 10 | 11 | 12 | 13 | 14 | 15 |
| S(x) | 405 | 529 | 97 | 11 | 333 | 509 | 40 | 198 |
| x | 16 | 17 | 18 | 19 | 20 | 21 | 22 | 23 |
| S(x) | 236 | 454 | 428 | 124 | 273 | 493 | 73 | 389 |
| x | 24 | 25 | 26 | 27 | 28 | 29 | 30 | 31 |
| S(x) | 162 | 293 | 2 | 211 | 467 | 252 | 411 | 183 |
| x | 32 | 33 | | | | | | |
| S(x) | 310 | 86 | | | | | | |

**Table 10 S look-up table for PB264**

| | | | | | | | | |
|---|---|---|---|---|---|---|---|---|
| x | 0 | 1 | 2 | 3 | 4 | 5 | 6 | 7 |
| S(x) | 309 | 175 | 737 | 667 | 1024 | 224 | 622 | 962 |
| x | 8 | 9 | 10 | 11 | 12 | 13 | 14 | 15 |
| S(x) | 527 | 845 | 926 | 1052 | 366 | 54 | 249 | 784 |
| x | 16 | 17 | 18 | 19 | 20 | 21 | 22 | 23 |
| S(x) | 108 | 551 | 410 | 479 | 823 | 866 | 442 | 654 |
| x | 24 | 25 | 26 | 27 | 28 | 29 | 30 | 31 |
| S(x) | 321 | 33 | 85 | 610 | 730 | 765 | 1038 | 352 |
| x | 32 | | | | | | | |
| S(x) | 954 | | | | | | | |

**Table 11 S look-up table for PB520**

| | | | | | | | | |
|---|---|---|---|---|---|---|---|---|
| x | 0 | 1 | 2 | 3 | 4 | 5 | 6 | 7 |
| S(x) | 1183 | 32 | 425 | 1434 | 165 | 331 | 1574 | 1039 |
| x | 8 | 9 | 10 | 11 | 12 | 13 | 14 | 15 |
| S(x) | 1084 | 1332 | 1513 | 536 | 213 | 1908 | 761 | 1231 |
| x | 16 | 17 | 18 | 19 | 20 | 21 | 22 | 23 |
| S(x) | 1659 | 476 | 1842 | 809 | 2007 | 895 | 1717 | 1950 |
| x | 24 | 25 | 26 | 27 | 28 | 29 | 30 | 31 |
| S(x) | 101 | 937 | 618 | 1606 | 704 | 1786 | 570 | 843 |
| x | 32 | 33 | 34 | 35 | 36 | 37 | 38 | 39 |
| S(x) | 349 | 2038 | 1102 | 1260 | 235 | 40 | 648 | 1347 |

A puncturing module punctures Turbo coded bits for output according to a required code rate. The information bits are not punctured, and the puncturing module punctures only p and q parity bits outputted from ENC1 and ENC2 and writes them into a parity output buffer in an original order. For different code rates, puncturing modes are shown in Table 12 and Table 13.

**Table 12 Puncturing mode for a code rate of 1/2**

| | |
|---|---|
| p | 11111111 |
| q | 11111111 |

**Table 13 Puncturing mode for a code rate of 4/5**

| | |
|---|---|
| p | 10001000 |
| q | 10001000 |

The flow of a puncturing algorithm is described below. In step 1, the puncturing mode is set according to the code rate. In step 2, the check bits of the Turbo coded bits are punctured from right (least significant bit) to left (most significant bit) according to the puncturing mode. Finally, the remaining Turbo coded bits after puncturing are arranged and outputted, where the information bits are outputted in sequence and then the check bits are outputted.

The PSDU data is scrambled in the same manner as the SIG data. The channel interleaving is performed on the PSDU data in the same manner as the PHR data. The PSDU data has basically the same diversity copying strategy as the PHR except that the PSDU data is copied once, twice or four times. Details are not repeated here.

In step 103, the constellation mapping is performed on each of the processed SIG data, the processed PHR data, and the processed PSDU data in a preset mapping manner, power-controlled pilot data is inserted to each of the processed SIG data, the processed PHR data, and the processed PSDU data, and an inverse Fourier transform is performed on the SIG data inserted with the pilot data, the PHR data inserted with the pilot data, and the PSDU data inserted with the pilot data for conversion into time domain.

In an embodiment, the pilot data is generated from a PN10 sequence with all initial values being 1; a first output bit of a pseudo-noise (PN) sequence is placed on a pilot subcarrier corresponding to Pilot Tone #1 in set 1, that is, the first output bit of the PN sequence is placed on the pilot subcarrier corresponding to Pilot Tone #1 in set 1 and subsequent bits are placed on corresponding pilot subcarriers in sequence; and pilot subcarriers uniformly use a binary phase shift keying (BPSK) modulation manner.

In an embodiment, the method further includes the step described below.

Before the inverse Fourier transform is performed on the SIG data inserted with the pilot data, the PHR data inserted with the pilot data, and the PSDU data inserted with the pilot data, phase conversion is performed on the SIG data inserted with the pilot data, the PHR data inserted with the pilot data, and the PSDU data inserted with the pilot data, where reference phases include carrier No. -64 to carrier No. 63.

In the embodiment of the present application, the power-controlled pilot data is inserted into each of the SIG data subjected to the constellation mapping, the PHR data subjected to the constellation mapping, and the PSDU data subjected to the constellation mapping. The pilot data is generated from the PN10 sequence with all the initial values being 1. The first output bit of the PN sequence is placed on the pilot subcarrier corresponding to Pilot Tone #1 in set 1, and the subsequent bits are placed on pilot subcarriers corresponding to #2, ..., #End in sequence. The PN sequence is generated in the same manner as PSDU scrambling codes are generated. The pilot subcarriers uniformly use the BPSK modulation manner. Phase rotation is performed on the SIG data inserted with the pilot data, the PHR data inserted with the pilot data, and the PSDU data inserted with the pilot data.

In the present application, the SIG data, the PHR data, and the PSDU data are mapped in different manners. For example, the SIG data may be mapped using BPSK, the PHR data may be mapped using BPSK and quadrature phase-shift keying (QPSK), and the modulation manner of the PSDU data may be extended so as to support BPSK, QPSK, and 16 quadrature amplitude modulation (16QAM). For different modulation manners of the SIG data, the PHR data, and the PSDU data, each carrier modulation signal can carry different numbers of bits. For example, for the QPSK, each carrier carries 2 bits and for the BPSK, each carrier carries 1 bit.

The power-controlled pilot is inserted after modulation. The number of pilot subcarriers, the number of empty carriers, and the number of pilot sets in different OFDM options are shown in Table 14.

**Table 14 Pilot parameters in different OFDM options**

| Parameter | OFDM Option 1 | OFDM Option 2 | OFDM Option 3 |
|---|---|---|---|
| Number of available carriers | 104 | 52 | 20 |
| Number of pilot carriers | 8 | 4 | 2 |
| Number of data carriers | 96 | 48 | 18 |
| Number of direct current carriers | 1 | 1 | 1 |
| Number of pilot sets | 7 | 7 | 3 |

After a long training field (LTF) frame, each OFDM symbol on an SIG data frame to a PSDU data frame uses one pilot set in sequence. Subcarrier loading indexes in option 1 to option 3 are shown in Table 15 to Table 17.

**Table 15 Pilot sets in option 1**

| Pilot Tone | #1 | #2 | #3 | #4 | #5 | #6 | #7 | #8 |
|---|---|---|---|---|---|---|---|---|
| Pilot set 1 | -52 | -38 | -22 | -10 | 2 | 14 | 30 | 42 |
| Pilot set 2 | -49 | -34 | -18 | -6 | 18 | 26 | 34 | 46 |
| Pilot set 3 | -46 | -30 | -14 | -2 | 6 | 22 | 38 | 49 |
| Pilot set 4 | -52 | -42 | -26 | -10 | 10 | 26 | 42 | 52 |
| Pilot set 5 | -49 | -38 | -22 | -6 | 2 | 14 | 30 | 46 |
| Pilot set 6 | -46 | -34 | -26 | -18 | 6 | 18 | 34 | 49 |
| Pilot set 7 | -42 | -30 | -14 | -2 | 10 | 22 | 38 | 52 |

**Table 16 Pilot sets in option 2**

| Pilot Tone | #1 | #2 | #3 | #4 |
|---|---|---|---|---|
| Pilot set 1 | -26 | -6 | 2 | 22 |
| Pilot set 2 | -18 | -10 | 10 | 18 |
| Pilot set 3 | -22 | -2 | 6 | 26 |
| Pilot set 4 | -14 | -6 | 14 | 22 |
| Pilot set 5 | -26 | -18 | 2 | 10 |
| Pilot set 6 | -10 | -2 | 18 | 26 |
| Pilot set 7 | -22 | -14 | 6 | 14 |

**Table 17 Pilot sets in option 3**

| Pilot Tone | #1 | #2 |
|---|---|---|
| Pilot set 1 | -10 | 2 |
| Pilot set 2 | -2 | 10 |
| Pilot set 3 | -6 | 6 |

The phase rotation is performed on the SIG data inserted with pilots, the PHR data inserted with pilots, and the PSDU data inserted with pilots. The reference phases are used for the phase rotation on SIG, PHR, and PSDU, and reference phase values of carrier No. -64 to carrier No. 63 are shown in Table 18. An actual phase is π/4 multiplied by a phase angle reference value corresponding to each carrier.

**Table 18 Data mapping phase table**

| Carrier No. | Phase No. | Carrier No. | Phase No. | Carrier No. | Phase No. | Carrier No. | Phase No. |
|---|---|---|---|---|---|---|---|
| -64 | 1 | -32 | 0 | 0 | 1 | 32 | 7 |
| -63 | 1 | -31 | 3 | 1 | 6 | 33 | 2 |
| -62 | 3 | -30 | 7 | 2 | 4 | 34 | 4 |
| -61 | 7 | -29 | 1 | 3 | 5 | 35 | 5 |
| -60 | 7 | -28 | 2 | 4 | 7 | 36 | 6 |
| -59 | 0 | -27 | 6 | 5 | 0 | 37 | 7 |
| -58 | 3 | -26 | 0 | 6 | 6 | 38 | 7 |
| -57 | 7 | -25 | 4 | 7 | 0 | 39 | 3 |
| -56 | 5 | -24 | 1 | 8 | 4 | 40 | 2 |
| -55 | 1 | -23 | 6 | 9 | 1 | 41 | 6 |
| -54 | 4 | -22 | 3 | 10 | 4 | 42 | 1 |
| -53 | 2 | -21 | 3 | 11 | 4 | 43 | 7 |
| -52 | 4 | -20 | 2 | 12 | 1 | 44 | 7 |
| -51 | 0 | -19 | 0 | 13 | 0 | 45 | 4 |
| -50 | 4 | -18 | 1 | 14 | 4 | 46 | 0 |
| -49 | 5 | -17 | 3 | 15 | 2 | 47 | 6 |
| -48 | 3 | -16 | 6 | 16 | 1 | 48 | 2 |
| -47 | 5 | -15 | 1 | 17 | 4 | 49 | 6 |
| -46 | 5 | -14 | 7 | 18 | 5 | 50 | 6 |
| -45 | 1 | -13 | 6 | 19 | 6 | 51 | 7 |
| -44 | 5 | -12 | 1 | 20 | 5 | 52 | 1 |
| -43 | 1 | -11 | 3 | 21 | 5 | 53 | 5 |
| -42 | 5 | -10 | 7 | 22 | 5 | 54 | 2 |
| -41 | 5 | -9 | 7 | 23 | 2 | 55 | 7 |
| -40 | 2 | -8 | 4 | 24 | 7 | 56 | 7 |
| -39 | 4 | -7 | 1 | 25 | 6 | 57 | 7 |
| -38 | 2 | -6 | 0 | 26 | 1 | 58 | 0 |
| -37 | 2 | -5 | 6 | 27 | 7 | 59 | 5 |
| -36 | 3 | -4 | 2 | 28 | 5 | 60 | 6 |
| -35 | 1 | -3 | 2 | 29 | 3 | 61 | 0 |
| -34 | 3 | -2 | 3 | 30 | 6 | 62 | 5 |
| -33 | 7 | -1 | 5 | 31 | 4 | 63 | 7 |

The SIG, PHR, and PSDU subjected to the preceding processing (pilot insertion and phase conversion) are converted into the time domain through the inverse fast Fourier transform (IFFT). Different modulation manners correspond to different power normalization factors. For example, if the QPSK is used, a power normalization factor is $1 / \sqrt{2}$.

In step 104, a cyclic prefix is added to each of the SIG data converted into the time domain, the PHR data converted into the time domain, and the PSDU data converted into the time domain so as to generate OFDM symbols corresponding to the SIG data, OFDM symbols corresponding to the PHR data, and OFDM symbols corresponding to the PSDU data, respectively.

In step 105, an inverse Fourier transform and power control are performed on preamble signal data generated in frequency domain so as to acquire time domain preamble signal data.

In an embodiment, the preamble signal data includes short training field (STF) data and long training field (LTF) data. It is to be noted that the preamble signal data in the present application is fixedly designed through respective communication bandwidths in different communication modes of the physical layer.

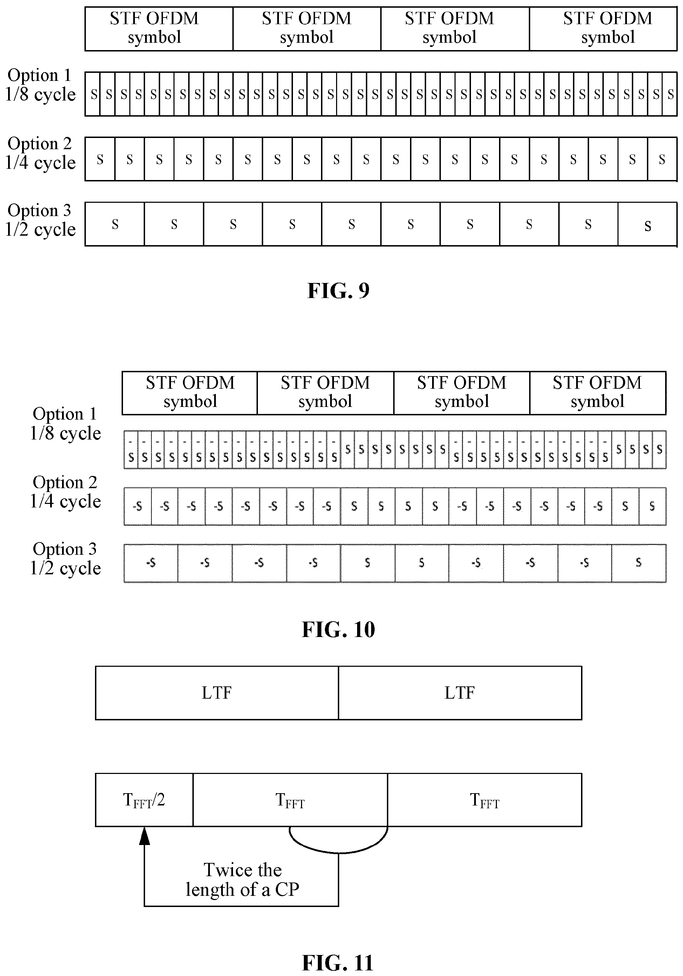

In the embodiment of the present application, an STF format and an LTF format of a preamble signal are shown in FIGS. 10 and 11. An STF frame is obtained by a dot product of sequences in a basic layer and a scrambling code layer. The scrambling code layer is composed of a 10-bit sequence. The sequence in the scrambling code layer is [-1 -1 -1 -1 1 1 -1 -1 -1 1] regardless of OFDM options. As shown in FIG. 9 which is a schematic diagram of a format of a time domain frame in the STF basic layer. An STF sequence has four STF OFDM symbols in total, and a length of a cyclic prefix (CP) added before each OFDM symbol is 1/4 a length of the OFDM symbol. In option 1, there are 8 sets of repeated data within each symbol with an FFT length, in option 2, there are 4 sets of repeated data within each symbol with an FFT length, and in option 3, there are 2 sets of repeated data within each symbol with an FFT length. The IFFT is performed on the data in the following table according to the following formula so that the sequence in the basic layer in the time domain can be obtained: $f \left(n\right) = \frac{1}{\sqrt{N}} {\sum }_{k = 0}^{N - 1} F \left(k\right) {e}^{j 2 πnk / N} .$

Frequency domain data in each option is shown below. An STF sequence in each OFDM option is different. In option 1, an STF frequency domain sequence is shown in Table 19, and the normalization factor is sqrt(104/12).

**Table 19 STF frequency domain sequence in option 1**

| Tone # | Value | Tone # | Value | Tone # | Value | Tone # | Value |
|---|---|---|---|---|---|---|---|
| -64 | 0 | -32 | -2.9439 | 0 | 0 | 32 | -2.9439 |
| -63 | 0 | -31 | 0 | 1 | 0 | 33 | 0 |
| -62 | 0 | -30 | 0 | 2 | 0 | 34 | 0 |
| -61 | 0 | -29 | 0 | 3 | 0 | 35 | 0 |
| -60 | 0 | -28 | 0 | 4 | 0 | 36 | 0 |
| -59 | 0 | -27 | 0 | 5 | 0 | 37 | 0 |
| -58 | 0 | -26 | 0 | 6 | 0 | 38 | 0 |
| -57 | 0 | -25 | 0 | 7 | 0 | 39 | 0 |
| -56 | 0 | -24 | -2.9439 | 8 | -2.9439 | 40 | 2.9439 |
| -55 | 0 | -23 | 0 | 9 | 0 | 41 | 0 |
| -54 | 0 | -22 | 0 | 10 | 0 | 42 | 0 |
| -53 | 0 | -21 | 0 | 11 | 0 | 43 | 0 |
| -52 | 0 | -20 | 0 | 12 | 0 | 44 | 0 |
| -51 | 0 | -19 | 0 | 13 | 0 | 45 | 0 |
| -50 | 0 | -18 | 0 | 14 | 0 | 46 | 0 |
| -49 | 0 | -17 | 0 | 15 | 0 | 47 | 0 |
| -48 | -2.9439 | -16 | 2.9439 | 16 | 2.9439 | 48 | -2.9439 |
| -47 | 0 | -15 | 0 | 17 | 0 | 49 | 0 |
| -46 | 0 | -14 | 0 | 18 | 0 | 50 | 0 |
| -45 | 0 | -13 | 0 | 19 | 0 | 51 | 0 |
| -44 | 0 | -12 | 0 | 20 | 0 | 52 | 0 |
| -43 | 0 | -11 | 0 | 21 | 0 | 53 | 0 |
| -42 | 0 | -10 | 0 | 22 | 0 | 54 | 0 |
| -41 | 0 | -9 | 0 | 23 | 0 | 55 | 0 |
| -40 | -2.9439 | -8 | 2.9439 | 24 | 2.9439 | 56 | 0 |
| -39 | 0 | -7 | 0 | 25 | 0 | 57 | 0 |
| -38 | 0 | -6 | 0 | 26 | 0 | 58 | 0 |
| -37 | 0 | -5 | 0 | 27 | 0 | 59 | 0 |
| -36 | 0 | -4 | 0 | 28 | 0 | 60 | 0 |
| -35 | 0 | -3 | 0 | 29 | 0 | 61 | 0 |
| -34 | 0 | -2 | 0 | 30 | 0 | 62 | 0 |
| -33 | 0 | -1 | 0 | 31 | 0 | 63 | 0 |

In option 2, an STF frequency domain sequence is shown in Table 20, and the normalization factor is sqrt(52/12).

**Table 20 STF frequency domain sequence in option 2**

| Tone # | Value | Tone # | Value | Tone # | Value | Tone # | Value |
|---|---|---|---|---|---|---|---|
| -32 | 0 | -16 | -2.0817 | 0 | 0 | 16 | -2.0817 |
| -31 | 0 | -15 | 0 | 1 | 0 | 17 | 0 |
| -30 | 0 | -14 | 0 | 2 | 0 | 18 | 0 |
| -29 | 0 | -13 | 0 | 3 | 0 | 19 | 0 |
| -28 | 0 | -12 | -2.0817 | 4 | -2.0817 | 20 | 2.0817 |
| -27 | 0 | -11 | 0 | 5 | 0 | 21 | 0 |
| -26 | 0 | -10 | 0 | 6 | 0 | 22 | 0 |
| -25 | 0 | -9 | 0 | 7 | 0 | 23 | 0 |
| -24 | -2.0817 | -8 | 2.0817 | 8 | 2.0817 | 24 | -2.0817 |
| -23 | 0 | -7 | 0 | 9 | 0 | 25 | 0 |
| -22 | 0 | -6 | 0 | 10 | 0 | 26 | 0 |
| -21 | 0 | -5 | 0 | 11 | 0 | 27 | 0 |
| -20 | -2.0817 | -4 | 2.0817 | 12 | 2.0817 | 28 | 0 |
| -19 | 0 | -3 | 0 | 13 | 0 | 29 | 0 |
| -18 | 0 | -2 | 0 | 14 | 0 | 30 | 0 |
| -17 | 0 | -1 | 0 | 15 | 0 | 31 | 0 |

In option 3, an STF frequency domain sequence is shown in Table 21, and the normalization factor is sqrt(20/10).

**Table 21 STF frequency domain sequence in option 3**

| Tone # | Value | Tone # | Value | Tone # | Value | Tone # | Value |
|---|---|---|---|---|---|---|---|
| -16 | 0 | -8 | -1.4142 | 0 | 0 | 8 | -1.4142 |
| -15 | 0 | -7 | 0 | 1 | 0 | 9 | 0 |
| -14 | 0 | -6 | 1.4142 | 2 | 1.4142 | 10 | -1.4142 |
| -13 | 0 | -5 | 0 | 3 | 0 | 11 | 0 |
| -12 | 0 | -4 | -1.4142 | 4 | -1.4142 | 12 | 0 |
| -11 | 0 | -3 | 0 | 5 | 0 | 13 | 0 |
| -10 | 1.4142 | -2 | -1.4142 | 6 | -1.4142 | 14 | 0 |
| -9 | 0 | -1 | 0 | 7 | 0 | 15 | 0 |

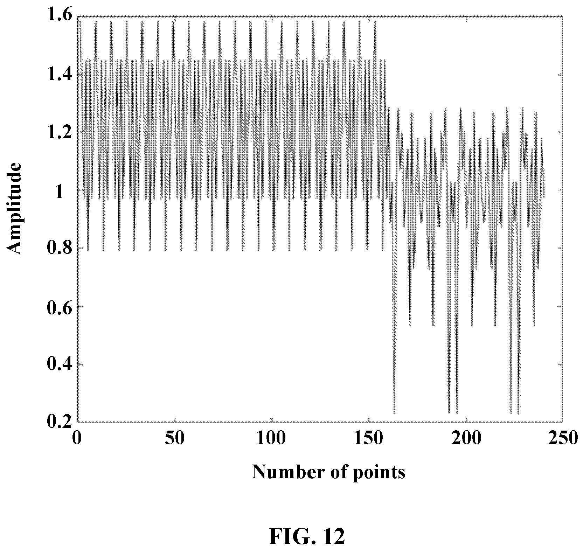

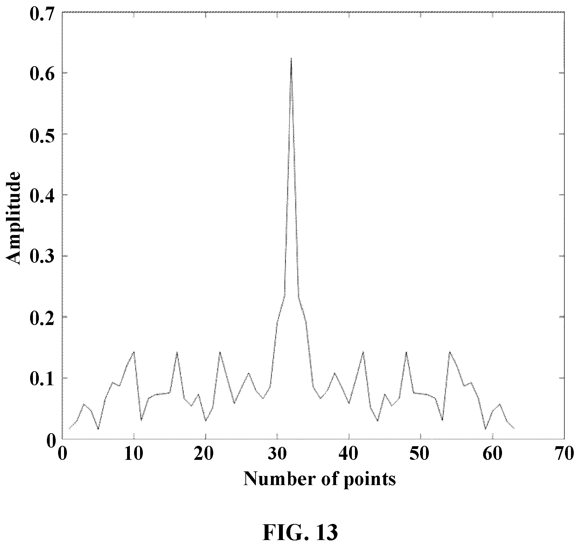

FIG. 12 is a time domain graph of modules of power-controlled STF and LTF of a preamble sequence at a bandwidth of 200 kHz according to an embodiment of the present application. FIG. 13 is a graph of an autocorrelation characteristic of LFT in a preamble sequence at a bandwidth of 200 kHz according to an embodiment of the present application.

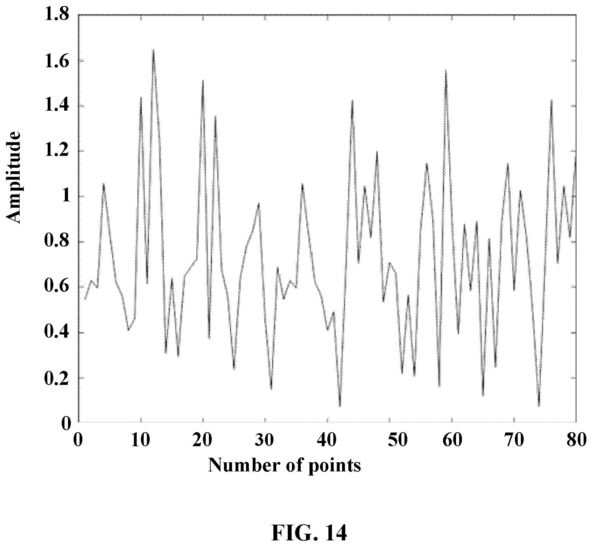

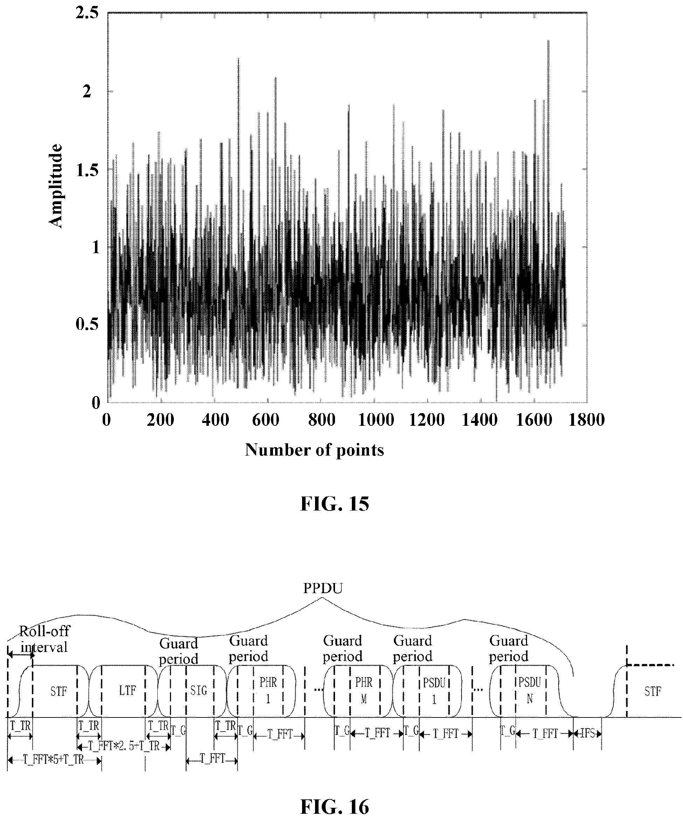

FIG. 14 is a time domain graph of an SIG module generated using a data phase mapping table at a bandwidth of 200 kHz according to an embodiment of the present application. FIG. 15 is a time domain graph of a PHR frame module generated using a data phase mapping table at a bandwidth of 200 kHz according to an embodiment of the present application.

In step 106, the time domain preamble signal data, the OFDM symbols corresponding to the SIG data, the OFDM symbols corresponding to the PHR data, and the OFDM symbols corresponding to the PSDU data are windowed so as to generate an OFDM-based frame signal which enters an analog front end.

In an embodiment, the OFDM-based frame signal includes the preamble signal data, the SIG data, the PHR data, and the PSDU data.

In the embodiment of the present application, to suppress out-of-band leakage, OFDM symbols to which CPs are added are windowed in the time domain so as to generate the OFDM-based frame signal which enters the analog front end. Window functions in option 1 to option 3 are defined as shown in Table 22 to Table 24.

**Table 22 Definition of window functions in option 1**

| n | *wᵣᵢₛₑ*[*n*] | *w_{fall}*[*n*] |
|---|---|---|
| 1 | 0.058824 | 0.882353 |
| 2 | 0.176471 | 0.764706 |
| 3 | 0.294118 | 0.647059 |
| 4 | 0.411765 | 0.529412 |
| 5 | 0.529412 | 0.411765 |
| 6 | 0.647059 | 0.294118 |
| 7 | 0.764706 | 0.176471 |
| 8 | 0.882353 | 0.058824 |

**Table 23 Definition of window functions in option 2**

| n | *wᵣᵢₛₑ*[*n*] | *w_{fall}*[*n*] |
|---|---|---|
| 1 | 0.111111 | 0.777778 |
| 2 | 0.333333 | 0.555556 |
| 3 | 0.555556 | 0.333333 |
| 4 | 0.777778 | 0.111111 |

**Table 24 Definition of window functions in option 3**

| n | *wᵣᵢₛₑ*[*n*] | *w_{fall}*[*n*] |
|---|---|---|
| 1 | 0.270741 | 0.879998 |
| 2 | 0.436767 | 0.672605 |
| 3 | 0.672605 | 0.436767 |
| 4 | 0.879998 | 0.270741 |

The entire STF data (with a length of 5 OFDM symbols) is windowed, the length of the windowed STF is 5 × IFFT length + 1 × roll-off interval, data at the front of the STF, the number of which is equal to the roll-off interval, is a copy of data at the rear of the STF and multiplied by *wᵣᵢₛₑ*[*n*] and overlaps with no signal, and data at the rear of the STF, the number of which is equal to the roll-off interval, is multiplied by *w_{fall}*[*n*] and added to data of the LTF multiplied by *wᵣᵢₛₑ*[*n*], where the number of the data of the LTF is equal to the roll-off interval.

The entire LTF data (with a length of 2.5 OFDM symbols) is windowed, the length of the windowed LTF is 2.5 × IFFT length + 1 × roll-off interval, data at the front of the LTF, the number of which is equal to the roll-off interval, is a copy of data at the rear of the LTF and multiplied by *wᵣᵢₛₑ*[*n*] and added to the data at the rear of the STF multiplied by *w_{fall}*[*n*], where the number of the data at the rear of the STF is equal to the roll-off interval, and data at the rear of the preamble LTF, the number of which is equal to the roll-off interval, is multiplied by *w_{fall}*[*n*] and added to data at the front of a first OFDM symbol multiplied by *wᵣᵢₛₑ*[*n*], where the number of the data at the front of the first OFDM symbol is equal to the roll-off interval.

Each OFDM symbol of SIG, PHR, and PSDU is added with the cyclic prefix and windowed, data at the front of each OFDM symbol, the number of which is equal to the roll-off interval, is multiplied by *wᵣᵢₛₑ*[*n*] and added to data at the rear of a previous OFDM symbol multiplied by *w_{fall}*[*n*], where the number of the data at the rear of the previous OFDM symbol is equal to the roll-off interval, and data at the rear of a last OFDM symbol, the number of which is equal to the roll-off interval, is multiplied by *w_{fall}*[*n*] and overlaps with no signal.

The generated OFDM-based frame signal enters the analog front end, where a format of the frame signal is shown in FIG. 16. A frame structure in the physical layer consists of a preamble, the SIG data, the PHR data, and the PSDU data. The characteristics of OFDM symbols in the physical layer are shown in Table 3.

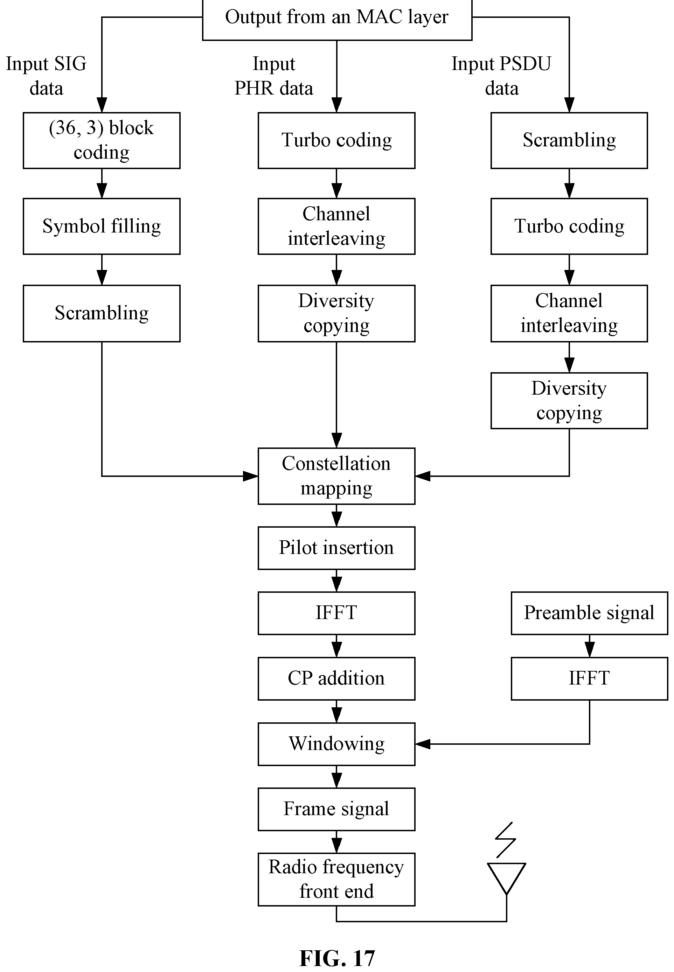

FIG. 17 is a schematic diagram of the generation of a frame signal according to an embodiment of the present application. As shown in FIG. 17, a process for generating the frame signal in the embodiment of the present application includes the steps described below. In S1, the physical layer receives the input from a medium access control (MAC) sublayer and divides the data from the MAC sublayer into the signal fields (SIG) data, the physical-layer header (PHR) data, and the physical-layer service data unit (PSDU) data. In S2, the (36, 3) block coding, the symbol filling, and the scrambling are performed on the SIG data. In S3, the Turbo coding, the channel interleaving and the diversity copying are performed on the PHR data. In S4, the scrambling, the Turbo coding, the channel interleaving, and the diversity copying are performed on the PSDU data. In S5, the processed SIG data, the processed PHR data, and the processed PSDU data are sent together for the constellation mapping and inserted with the power-controlled pilot data separately. In S6, the IFFT is performed on the SIG data inserted with the pilot data, the PHR data inserted with the pilot data, and the PSDU data inserted with the pilot data for conversion into the time domain. In S7, the cyclic prefixes are added to the SIG data converted into the time domain, the PHR data converted into the time domain, and the PSDU data converted into the time domain so as to generate OFDM symbols. In S8, preamble signal data is generated and subjected to the IFFT and the power control so as to acquire the time domain preamble signal data. In S9, the time domain preamble signal data, the OFDM symbols of the SIG data, the OFDM symbols of the PHR data, and the OFDM symbols of the PSDU data are windowed. In S10, an OFDM frame signal is generated and enters into the analog front end (that is, a radio frequency front end in FIG. 17).

In the embodiment of the present application, the frequency band efficiency and the capability to resist channel multipath fading of the high-speed wireless communication are improved by using the OFDM technology. Meanwhile, the error rates of the SIG data, the PHR data, and the PSDU data are reduced in manners such as the Turbo coding, the channel interleaving, and the diversity copying, improving the robustness of the system. The phase rotation factor is added during the constellation mapping, reducing the peak-to-average ratio of the OFDM symbols and greatly improving the power amplification efficiency of the system.

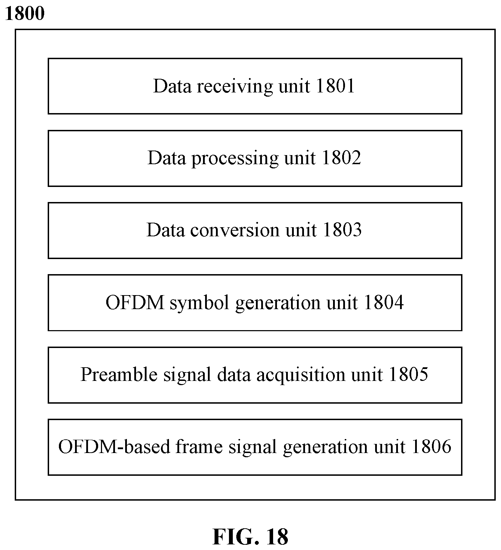

FIG. 18 is a structural diagram of an OFDM-based high-speed wireless communication physical layer transmission signal generation system 1800 according to an embodiment of the present application. As shown in FIG. 18, the OFDM-based high-speed wireless communication physical layer transmission signal generation system 1800 provided in the embodiment of the present application includes a data receiving unit 1801, a data processing unit 1802, a data conversion unit 1803, an OFDM symbol generation unit 1804, a preamble signal data acquisition unit 1805, and an OFDM-based frame signal generation unit 1806.

In an embodiment, the data receiving unit 1801 is configured to receive output data from a medium access control (MAC) layer, determine physical-layer header (PHR) data according to a modulation and coding scheme of physical-layer service data unit (PSDU) data in the output data, and determine signal fields (SIG) data according to a modulation and coding scheme of the PHR data.

In an embodiment, the data processing unit 1802 is configured to process each of the SIG data, the PHR data, and the PSDU data in a respective preset processing manner to acquire the processed SIG data, the processed PHR data, and the processed PSDU data.

In an embodiment, the data processing unit 1802 is configured to process each of the SIG data, the PHR data, and the PSDU data in the respective preset processing manner to acquire the processed SIG data, the processed PHR data, and the processed PSDU data, and the data processing unit 1802 includes an SIG data processing module, a PHR data processing module, and a PSDU data processing module.

The SIG data processing module is configured to perform (36, 3) block coding, symbol filling, and scrambling on the SIG data in sequence to acquire the processed SIG data.

The PHR data processing module is configured to perform Turbo coding, channel interleaving, and diversity copying on the PHR data in sequence to acquire the processed PHR data.

The PSDU data processing module is configured to perform scrambling, Turbo coding, channel interleaving, and diversity copying on the PSDU data in sequence to acquire the processed PSDU data.

In an embodiment, the PHR data processing module and the PSDU data processing module are further configured to perform the Turbo coding on the PHR data and the PSDU data respectively by using a Turbo encoder.

The Turbo encoder includes a Turbo interleaver, a first component encoder, and a second component encoder; the PHR data and the PSDU data are each used as an input signal of the first component encoder and an input signal of the Turbo interleaver, and an output signal of the Turbo interleaver is used as an input signal of the second component encoder; the Turbo interleaver interleaves the PHR data in units of double bits, where an interleaving length is equal to the number of double bits included in a block length of the PHR data, and the Turbo interleaver interleaves the PSDU data in units of double bits, where an interleaving length is equal to the number of double bits included in a block length of the PSDU data; and the Turbo interleaver selects different code rates according to different requirements.

In an embodiment, when the Turbo coding is performed on the PHR data, a Turbo code block has a length of PB 16 and supports a code rate of 1/2 and a code rate of 4/5.

The PSDU data supports six modes, PB16, PB40, PB72, PB136, PB264, and PB520, each mode supports a code rate of 1/2 and a code rate of 4/5, and when the Turbo coding is performed on the PSDU data, different code block lengths and different code rates are selected according to different requirements.

In an embodiment, the PHR data processing module and the PSDU data processing module are further configured to perform the steps described below.

When the channel interleaving is performed on Turbo coded PHR data and Turbo coded PSDU data, each of the Turbo coded PHR data and the Turbo coded PSDU data is divided into information codes and check codes which are interleaved separately; where when the information codes are interleaved, information bits of the information codes are inputted in columns and outputted in rows, and different rows are read such that the information codes are disarranged; and the check codes are interleaved in the same manner as interleaving the information codes except that the check codes are read from an offset address.

Interleaved information codes and interleaved check codes are interleaved in a manner determined according to a code rate that is calculated according to the information codes and the check codes.

In an embodiment, the PHR data processing module and the PSDU data processing module perform the diversity copying on data, which includes diversity and mapping on each of the PHR data and the PSDU data.

In an embodiment, the data conversion unit 1803 is configured to perform a constellation mapping on the processed SIG data, the processed PHR data, and the processed PSDU data in a preset mapping manner, separately, insert power-controlled pilot data separately, and perform an inverse Fourier transform on the SIG data inserted with the pilot data, the PHR data inserted with the pilot data, and the PSDU data inserted with the pilot data for conversion into time domain.

In an embodiment, the data conversion unit 1803 is further configured to, before performing the inverse Fourier transform on the SIG data inserted with the pilot data, the PHR data inserted with the pilot data, and the PSDU data inserted with the pilot data, perform phase conversion on the SIG data inserted with the pilot data, the PHR data inserted with the pilot data, and the PSDU data inserted with the pilot data, where reference phases include carrier No. -64 to carrier No. 63.

In an embodiment, the OFDM symbol generation unit 1804 is configured to add a cyclic prefix to each of the SIG data converted into the time domain, the PHR data converted into the time domain, and the PSDU data converted into the time domain to generate OFDM symbols corresponding to the SIG data, OFDM symbols corresponding to the PHR data, and OFDM symbols corresponding to the PSDU data, respectively.

In an embodiment, the preamble signal data acquisition unit 1805 is configured to perform an inverse Fourier transform and power control on preamble signal data generated in frequency domain to acquire time domain preamble signal data.

In an embodiment, the OFDM-based frame signal generation unit 1806 is configured to window the time domain preamble signal data, the OFDM symbols corresponding to the SIG data, the OFDM symbols corresponding to the PHR data, and the OFDM symbols corresponding to the PSDU data to generate an OFDM-based frame signal which enters an analog front end.

In an embodiment, the pilot data is generated from a PN10 sequence with all initial values being 1; a first output bit of a PN sequence is placed on a pilot subcarrier corresponding to Pilot Tone #1 in set 1, and subsequent bits are placed on corresponding pilot subcarriers in sequence; and pilot subcarriers uniformly use a BPSK modulation manner; and the OFDM-based frame signal includes the preamble signal data, the SIG data, the **PHR** data, and the PSDU data, where the preamble signal data includes short training field (STF) data and long training field (LTF) data.

The OFDM-based high-speed wireless communication physical layer transmission signal generation system 1800 in the embodiment of the present application corresponds to the OFDM-based high-speed wireless communication physical layer transmission signal generation system 100 in another embodiment of the present application. Details are not repeated here.

The present application has been described with reference to a small number of embodiments. However, as is well-known to those skilled in the art, other embodiments except those disclosed above fall within the scope of the present application, as defined by the appended claims.

Generally, all terms used in the claims are interpreted according to their ordinary meanings in the art, unless explicitly defined otherwise therein. All references to "a/the [apparatus, component, or the like]" are interpreted openly as referring to at least one example of the apparatus, component, or the like, unless explicitly stated otherwise. The steps in any method disclosed herein do not have to be performed in an exact order disclosed, unless explicitly stated.

It is to be understood by those skilled in the art that embodiments of the present application may be provided as methods, systems, or computer program products. Therefore, the present application may take the form of an entirely hardware embodiment, an entirely software embodiment or an embodiment combining software and hardware aspects. Moreover, the present application may take the form of a computer program product implemented on one or more computer-usable storage media (including, but not limited to, a disk memory, a compact disc read-only memory (CD-ROM), an optical memory, and the like) that include computer-usable program codes.

The present application is described with reference to flowcharts and/or block diagrams of methods, devices (systems), and computer program products according to embodiments of the present application. It is to be understood that each flow and/or block in the flowcharts and/or block diagrams and a combination of flows and/or blocks in the flowcharts and/or block diagrams may be implemented by computer program instructions. These computer program instructions may be provided to a processor of a general-purpose computer, a special-purpose computer, an embedded processor, or another programmable data processing device to produce a machine so that instructions executed by the processor of the computer or another programmable data processing device create an apparatus for implementing functions specified in one or more flows in the flowcharts and/or in one or more blocks in the block diagrams.

These computer program instructions may also be stored in a computer-readable memory which can direct a computer or another programmable data processing device to operate in a particular manner so that instructions stored in the computer-readable memory create an article of manufacture including an instructing apparatus for implementing functions specified in one or more flows in the flowcharts and/or in one or more blocks in the block diagrams.

These computer program instructions may also be loaded onto a computer or another programmable data processing device so that a series of operation steps are performed on the computer or another programmable device to produce processing implemented by the computer. Therefore, instructions executed on the computer or another programmable device provide steps for implementing functions specified in one or more flows in the flowcharts and/or in one or more blocks in the block diagrams.

## Claims

1. An orthogonal frequency-division multiplexing, OFDM, based high-speed wireless communication physical layer transmission signal generation method, comprising:
receiving (101) output data from a medium access control, MAC, layer, determining (101) physical-layer header, PHR, data according to a modulation and coding scheme of physical-layer service data unit, PSDU, data in the output data, and determining (101) signal fields, SIG, data according to a modulation and coding scheme of the PHR data;
processing (102) each of the SIG data, the PHR data, and the PSDU data in a respective preset processing manner to acquire processed SIG data, processed PHR data, and processed PSDU data;
performing (103) a constellation mapping on each of the processed SIG data, the processed PHR data, and the processed PSDU data in a respective preset mapping manner, inserting (103) power-controlled pilot data to each of the processed SIG data, the processed PHR data, and the processed PSDU data, and performing (103) an inverse Fourier transform on each of the SIG data inserted with the pilot data, the PHR data inserted with the pilot data, and the PSDU data inserted with the pilot data for conversion into time domain;
adding (104) a cyclic prefix to each of the SIG data converted into the time domain, the PHR data converted into the time domain, and the PSDU data converted into the time domain to generate OFDM symbols corresponding to the SIG data, OFDM symbols corresponding to the PHR data, and OFDM symbols corresponding to the PSDU data, respectively;
performing (105) an inverse Fourier transform and power control on preamble signal data generated in frequency domain to acquire time domain preamble signal data; and
windowing (106) the time domain preamble signal data, the OFDM symbols corresponding to the SIG data, the OFDM symbols corresponding to the PHR data, and the OFDM symbols corresponding to the PSDU data, to generate an OFDM-based frame signal which enters an analog front end;
wherein the pilot data is generated from a pseudo-noise, PN, sequence with all initial values being 1; a first output bit of the PN sequence is placed on a pilot subcarrier corresponding to Pilot Tone #1 in set 1, subsequent bits are placed on corresponding pilot subcarriers in sequence, and pilot subcarriers uniformly use a binary phase-shift keying, BPSK, modulation manner;
the OFDM symbols have three options, wherein a fast Fourier transform, FFT, in option 1 has 128 points, an FFT in option 2 has 64 points, an FFT in option 3 has 32 point, and after a long training field, LTF, frame, each OFDM symbol on an SIG data frame to a PSDU data frame uses one pilot set in sequence;
the OFDM-based frame signal comprises the preamble signal data, the SIG data, the PHR data, and the PSDU data, wherein the preamble signal data comprises short training field, STF, data and LTF data;
the STF data is obtained by a dot product of sequences in a basic layer and a scrambling code layer, the scrambling code layer is composed of a 10-bit sequence, a sequence in the scrambling code layer is [-1 -1 -1 -1 1 1 -1 -1 -1 1] regardless of OFDM options, an STF sequence has four STF OFDM symbols, and a length of a cyclic prefix added before each OFDM symbol is 1/4 a length of the OFDM symbol, wherein in option 1, there are 8 sets of repeated data within each symbol with an FFT length, in option 2, there are 4 sets of repeated data within each symbol with an FFT length, and in option 3, there are 2 sets of repeated data within each symbol with an FFT length;
wherein the processing (102) each of the SIG data, the PHR data, and the PSDU data in a respective preset processing manners to acquire the processed SIG data, the processed PHR data, and the processed PSDU data comprises:
performing (36, 3) block coding, symbol filling, and scrambling on the SIG data in sequence to acquire the processed SIG data;
performing Turbo coding, channel interleaving, and diversity copying on the PHR data in sequence to acquire the processed PHR data, wherein the diversity copying is used for diversity and the mapping on the PHR data; and
performing scrambling, Turbo coding, channel interleaving, and diversity copying on the PSDU data in sequence to acquire the processed PSDU data, wherein the diversity copying is used for diversity and the mapping on the PSDU data.

2. The method of claim 1, wherein the Turbo coding is performed on each of the PHR data and the PSDU data by using a Turbo encoder, wherein the Turbo encoder comprises a Turbo interleaver, a first component encoder, and a second component encoder, wherein each time a pair of information bits is inputted, system bits and check bits are outputted; the PHR data and the PSDU data are each used as an input signal of the first component encoder and an input signal of the Turbo interleaver, and an output signal of the Turbo interleaver is used as an input signal of the second component encoder; the Turbo interleaver interleaves the PHR data in units of double bits, and an interleaving length is equal to a number of double bits comprised in a block length of the PHR data; the Turbo interleaver interleaves the PSDU data in units of double bits, and an interleaving length is equal to a number of double bits comprised in a block length of the PSDU data; and the Turbo interleaver selects different code rates according to different requirements.

3. The method of claim 1, wherein in response to performing the Turbo coding on the PHR data, a Turbo code block has a length of physical block 16, PB16 and supports a code rate of 1/2 and a code rate of 4/5; and
the PSDU data supports six modes, which are PB16, PB40, PB72, PB136, PB264, and PB520, each mode supports a code rate of 1/2 and a code rate of 4/5Turbo, and in response to performing the Turbo coding on the PSDU data, different code block lengths and different code rates are selected according to different requirements;
wherein a number of bytes of a physical block in PB16 is 16, a number of bytes of a physical block in PB40 is 40, a number of bytes of a physical block in PB72 is 72, a number of bytes of a physical block in PB136 is 136, a number of bytes of a physical block in PB264 is 264, and a number of bytes of a physical block in PB520 is 520.

4. The method of claim 1, wherein in response to performing the channel interleaving on Turbo coded PHR data and Turbo coded PSDU data, each of the Turbo coded PHR data and the Turbo coded PSDU data is divided into information codes and check codes which are interleaved separately; wherein in response to interleaving the information codes, information bits of the information codes are inputted in columns and outputted in rows, and different rows are read such that the information codes are disarranged; and the check codes are interleaved in a same manner as interleaving the information codes except that the check codes are read from an offset address; and
interleaved information codes and interleaved check codes are interleaved in a manner determined according to a code rate that is calculated according to the information codes and the check codes.

5. The method of claim 1, further comprising:
before the performing (103) the inverse Fourier transform on the SIG data inserted with the pilot data, the PHR data inserted with the pilot data, and the PSDU data inserted with the pilot data, performing phase rotation on the SIG data inserted with the pilot data, the PHR data inserted with the pilot data, and the PSDU data inserted with the pilot data, wherein reference phases are used for the phase rotation on SIG, PHR, and PSDU, the reference phase is π/4 multiplied by a phase angle reference value corresponding each carrier in 128 carriers.

6. An orthogonal frequency-division multiplexing, OFDM, based high-speed wireless communication physical layer transmission signal generation system, comprising a data receiving unit (1801), a data processing unit (1802), a data conversion unit (1803), an OFDM symbol generation unit (1804), a preamble signal data acquisition unit (1805), and an OFDM-based frame signal generation unit (1806); wherein
the data receiving unit (1801) is configured to receive output data from a medium access control, MAC, layer, determine physical-layer header, PHR, data according to a modulation and coding scheme of physical-layer service data unit, PSDU, data in the output data, and determine signal fields, SIG, data according to a modulation and coding scheme of the PHR data;
the data processing unit (1802) is configured to process each of the SIG data, the PHR data, and the PSDU data in a respective preset processing manner to acquire the processed SIG data, the processed PHR data, and the processed PSDU data;
the data conversion unit (1803) is configured to perform a constellation mapping on each of the processed SIG data, the processed PHR data, and the processed PSDU data in a respective preset mapping manner, insert power-controlled pilot data to each of the processed SIG data, the processed PHR data, and the processed PSDU data, and perform an inverse Fourier transform on each of the SIG data inserted with the pilot data, the PHR data inserted with the pilot data, and the PSDU data inserted with the pilot data for conversion into time domain;
the OFDM symbol generation unit (1804) is configured to add a cyclic prefix to each of the SIG data converted into the time domain, the PHR data converted into the time domain, and the PSDU data converted into the time domain to generate OFDM symbols corresponding to the SIG data, OFDM symbols corresponding to the PHR data, and OFDM symbols corresponding to the PSDU data, respectively;
the preamble signal data acquisition unit (1805) is configured to perform an inverse Fourier transform and power control on preamble signal data generated in frequency domain to acquire time domain preamble signal data; and
the OFDM-based frame signal generation unit (1806) is configured to window the time domain preamble signal data, the OFDM symbols corresponding to the SIG data, the OFDM symbols corresponding to the PHR data, and the OFDM symbols corresponding to the PSDU data to generate an OFDM-based frame signal which enters an analog front end;
wherein the pilot data is generated from a pseudo-noise, PN, sequence with all initial values being 1; a first output bit of the PN sequence is placed on a pilot subcarrier corresponding to Pilot Tone #1 in set 1, subsequent bits are placed on corresponding pilot subcarriers in sequence, and pilot subcarriers uniformly use a binary phase-shift keying, BPSK, modulation manner;
the OFDM symbols have three options, wherein a fast Fourier transform, FFT, in option 1 has 128 points, an FFT in option 2 has 64 points, an FFT in option 3 has 32 point, and after a long training field, LTF, frame, each OFDM symbol on an SIG data frame to a PSDU data frame uses one pilot set in sequence;
the OFDM-based frame signal comprises the preamble signal data, the SIG data, the PHR data, and the PSDU data, wherein the preamble signal data comprises short training field, STF, data and LTF data;
the STF data is obtained by a dot product of sequences in a basic layer and a scrambling code layer, the scrambling code layer is composed of a 10-bit sequence, a sequence in the scrambling code layer is [-1 -1 -1 -1 1 1 -1 -1 -1 1] regardless of OFDM options, an STF sequence has four STF OFDM symbols, and a length of a cyclic prefix added before each OFDM symbol is 1/4 a length of the OFDM symbol, wherein in option 1, there are 8 sets of repeated data within each symbol with an FFT length, in option 2, there are 4 sets of repeated data within each symbol with an FFT length, and in option 3, there are 2 sets of repeated data within each symbol with an FFT length;
wherein the data processing unit (1802) is configured to process each of the SIG data, the PHR data, and the PSDU data in the respective preset processing manner to acquire the processed SIG data, the processed PHR data, and the processed PSDU data, and the data processing unit comprises an SIG data processing module, a PHR data processing module, and a PSDU data processing module; wherein the SIG data processing module is configured to perform (36, 3) block coding, symbol filling, and scrambling on the SIG data in sequence to acquire the processed SIG data;
the PHR data processing module is configured to perform Turbo coding, channel interleaving, and diversity copying on the PHR data in sequence to acquire the processed PHR data; and
the PSDU data processing module is configured to perform scrambling, Turbo coding, channel interleaving, and diversity copying on the PSDU data in sequence to acquire the processed PSDU data;
wherein the diversity copying is used for diversity and the mapping on each of the PHR data and the PSDU data.

7. The system of claim 6, wherein the PHR data processing module and the PSDU data processing module are further configured to:
perform the Turbo coding on each of the PHR data and the PSDU data respectively by using a Turbo encoder, wherein the Turbo encoder comprises a Turbo interleaver, a first component encoder, and a second component encoder, wherein each time a pair of information bits is inputted, system bits and check bits are outputted; the PHR data and the PSDU data are each used as an input signal of the first component encoder and an input signal of the Turbo interleaver, and an output signal of the Turbo interleaver is used as an input signal of the second component encoder; the Turbo interleaver interleaves the PHR data in units of double bits, wherein an interleaving length is equal to a number of double bits comprised in a block length of the PHR data, and the Turbo interleaver interleaves the PSDU data in units of double bits, wherein an interleaving length is equal to a number of double bits comprised in a block length of the PSDU data; and the Turbo interleaver selects different code rates according to different requirements.

8. The system of claim 6, wherein in response to performing the Turbo coding on the PHR data, a Turbo code block has a length of physical block 16, PB16 and supports a code rate of 1/2 and a code rate of 4/5; and
the PSDU data supports six modes, which are PB16, PB40, PB72, PB136, PB264, and PB520, each mode supports a code rate of 1/2 and a code rate of 4/5, and in response to performing the Turbo coding on the PSDU data, different code block lengths and different code rates are selected according to different requirements;
wherein a number of bytes of a physical block in PB16 is 16, a number of bytes of a physical block in PB40 is 40, a number of bytes of a physical block in PB72 is 72, a number of bytes of a physical block in PB136 is 136, a number of bytes of a physical block in PB264 is 264, and a number of bytes of a physical block in PB520 is 520.

9. The system of claim 6, wherein the PHR data processing module and the PSDU data processing module are further configured to:
in response to performing the channel interleaving on Turbo coded PHR data and Turbo coded PSDU data, divide each of the Turbo coded PHR data and Turbo coded PSDU data into information codes and check codes which are interleaved separately; wherein in response to interleaving the information codes, information bits of the information codes are inputted in columns and outputted in rows, and different rows are read such that the information codes are disarranged; and the check codes are interleaved in a same manner as interleaving the information codes except that the check codes are read from an offset address; and
interleave interleaved information codes and interleaved check codes in a manner determined according to a code rate that is calculated according to the information codes and the check codes.

10. The system of claim 6, wherein the data conversion unit (1803) is further configured to:
before performing the inverse Fourier transform on the SIG data inserted with the pilot data, the PHR data inserted with the pilot data, and the PSDU data inserted with the pilot data, perform phase rotation on the SIG data inserted with the pilot data, the PHR data inserted with the pilot data, and the PSDU data inserted with the pilot data, wherein reference phases are used for the phase rotation on SIG, **PHR,** and PSDU, the reference phase is π/4 multiplied by a phase angle reference value corresponding each carrier in 128 carriers.

## Patentansprüche

1. Orthogonal-Frequency-Division-Multiplexing(OFDM)-basiertes Verfahren zur Erzeugung eines Physical-Layer-Übertragungssignals für eine drahtlose Hochgeschwindigkeitskommunikation, umfassend:
Empfangen (101) von Ausgangsdaten von einem Medium-Access-Control(MAC)-Layer, Bestimmen (101) von Physical-Layer-Header(PHR)-Daten gemäß einem Modulations- und Codierungsschema von Physical-Layer-Service-Data-Unit(PSDU)-Daten in den Ausgangsdaten und Bestimmen (101) von Signalfeld(SIG)-Daten gemäß einem Modulations- und Codierungsschema der PHR-Daten;
Verarbeiten (102) jeweils der SIG-Daten, der PHR-Daten und der PSDU-Daten in einer jeweiligen vorgegebenen Verarbeitungsweise, um verarbeitete SIG-Daten, verarbeitete PHR-Daten und verarbeitete PSDU-Daten zu erlangen;
Durchführen (103) eines Konstellationsmappings jeweils der verarbeiteten SIG-Daten, der verarbeiteten PHR-Daten und der verarbeiteten PSDU-Daten in einer jeweiligen vorgegebenen Mappingweise, Einfügen (103) leistungsgeregelter Pilotdaten jeweils in die verarbeiteten SIG-Daten, die verarbeiteten PHR-Daten und die verarbeiteten PSDU-Daten sowie Durchführen (103) einer inversen Fourier-Transformation jeweils für die SIG-Daten, in die die Pilotdaten eingefügt wurden, die PHR-Daten, in die die Pilotdaten eingefügt wurden, und die PSDU-Daten, in die die Pilotdaten eingefügt wurden, zur Umwandlung in den Zeitbereich;
Hinzufügen (104) eines zyklischen Präfixes jeweils zu den in den Zeitbereich umgewandelten SIG-Daten, den in den Zeitbereich umgewandelten PHR-Daten und den in den Zeitbereich umgewandelten PSDU-Daten, um jeweils OFDM-Symbole, die den SIG-Daten entsprechen, OFDM-Symbole, die den PHR-Daten entsprechen, und OFDM-Symbole, die den PSDU-Daten entsprechen, zu erzeugen;
Durchführen (105) einer inversen Fourier-Transformation und einer Leistungsregelung an in dem Frequenzbereich erzeugten Präambelsignaldaten, um Zeitbereichspräambelsignaldaten zu erlangen, und
Anwenden einer Fensterfunktion (106) auf die Zeitbereichspräambelsignaldaten, die OFDM-Symbole, die den SIG-Daten entsprechen, die OFDM-Symbole, die den PHR-Daten entsprechen, und die OFDM-Symbole, die den PSDU-Daten entsprechen, um ein OFDM-basiertes Framesignal zu erzeugen, das einem Analog-Front-End zugeführt wird,
wobei die Pilotdaten aus einer Pseudo-Noise(PN)-Sequenz erzeugt werden, wobei alle Anfangswerte 1 sind, wobei ein erstes Ausgangsbit der PN-Sequenz auf einem Pilotunterträger entsprechend Pilotton Nr. 1 in Satz 1 platziert wird, nachfolgende Bits sequenziell auf entsprechenden Pilotunterträgern platziert werden und die Pilotunterträger einheitlich eine Modulationsweise in Form einer binären Phasenumtastung, BPSK, verwenden,
wobei die OFDM-Symbole drei Optionen aufweisen, wobei eine schnelle Fourier-Transformation, FFT, in Option 1 128 Punkte aufweist, eine FFT in Option 2 64 Punkte aufweist, eine FFT in Option 3 32 Punkte aufweist und jedes OFDM-Symbol in einem SIG-Datenframe von einem Long-Training-Field(LTF)-Frame bis zu einem PSDU-Datenframe sequenziell einen Pilotsatz verwendet,
wobei das OFDM-basierte Framesignal die Präambelsignaldaten, die SIG-Daten, die PHR-Daten und die PSDU-Daten umfasst, wobei die Präambelsignaldaten Short-Training-Field(STF)-Daten und LTF-Daten umfassen,
wobei die STF-Daten durch ein Skalarprodukt von Sequenzen in einem Basis-Layer und einem Scrambling-Code-Layer erhalten werden, wobei der Scrambling-Code-Layer aus einer 10-Bit-Sequenz besteht, eine Sequenz in dem Scrambling-Code-Layer ungeachtet von OFDM-Optionen [-1 -1 -1-111 -1 -1-1 1] ist, eine STF-Sequenz vier STF-OFDM-Symbole aufweist und eine vor jedem OFDM-Symbol hinzugefügte Länge eines zyklischen Präfix 1/4 einer Länge des OFDM-Symbols ist, wobei es in Option 1 8 Sätze von wiederholten Daten innerhalb jedes Symbols mit einer FFT-Länge gibt, es in Option 2 4 Sätze von wiederholten Daten innerhalb jedes Symbols mit einer FFT-Länge gibt, und es in Option 3 2 Sätze von wiederholten Daten innerhalb jedes Symbols mit einer FFT-Länge gibt,
wobei das Verarbeiten (102) jeweils der SIG-Daten, der PHR-Daten und der PSDU-Daten in einer jeweiligen vorgegebenen Verarbeitungsweise, um die verarbeiteten SIG-Daten, die verarbeiteten PHR-Daten und die verarbeiteten PSDU-Daten zu erlangen, Folgendes umfasst:
sequenzielles Durchführen (36, 3) einer Blockcodierung, einer Symbolfüllung und eines Scramblings an den SIG-Daten, um die verarbeiteten SIG-Daten zu erlangen;
sequenzielles Durchführen einer Turbocodierung, eines Kanal-Interleavings und einer Diversity-Kopie an den PHR-Daten, um die verarbeiteten PHR-Daten zu erlangen, wobei die Diversity-Kopie für Diversity sowie zum Mapping der PHR-Daten verwendet wird, und
sequenzielles Durchführen eines Scramblings, einer Turbocodierung, eines Kanal-Interleavings und einer Diversity-Kopie an den PSDU-Daten, um die verarbeiteten PSDU-Daten zu erlangen, wobei die Diversity-Kopie für Diversity sowie zum Mapping der PSDU-Daten verwendet wird.

2. Verfahren nach Anspruch 1, wobei die Turbocodierung jeweils an den PHR-Daten und den PSDU-Daten durch Verwenden eines Turbo-Encoders durchgeführt wird, wobei der Turbo-Encoder einen Turbo-Interleaver, einen ersten Komponenten-Encoder und einen zweiten Komponenten-Encoder umfasst, wobei jeweils ein Paar Informationsbits eingegeben wird und Systembits und Prüfbits ausgegeben werden, wobei die PHR-Daten und die PSDU-Daten jeweils als Eingangssignal des ersten Komponenten-Encoders und als Eingangssignal des Turbo-Interleavers verwendet werden und ein Ausgangssignal des Turbo-Interleavers als Eingangssignal des zweiten Komponenten-Encoders verwendet wird, wobei der Turbo-Interleaver ein Interleaving der PHR-Daten in Einheiten von Doppelbits durchführt und eine Interleaving-Länge gleich einer Anzahl von Doppelbits ist, die in einer Blocklänge der PHR-Daten enthalten sind, wobei der Turbo-Interleaver ein Interleaving der PSDU-Daten in Einheiten von Doppelbits durchführt und eine Interleaving-Länge gleich einer Anzahl von Doppelbits ist, die in einer Blocklänge der PSDU-Daten enthalten sind, und der Turbo-Interleaver unterschiedliche Coderaten gemäß unterschiedlichen Anforderungen auswählt.

3. Verfahren nach Anspruch 1, wobei ein Turbo-Codeblock als Reaktion auf das Durchführen der Turbocodierung an den PHR-Daten eine Länge eines physischen Blocks 16, PB16, aufweist und eine Coderate von 1/2 und eine Coderate von 4/5 unterstützt, und
wobei die PSDU-Daten sechs Modi unterstützen, bei denen es sich um PB16, PB40, PB72, PB136, PB264 und PB520 handelt, wobei jeder Modus eine Coderate von 1/2 und eine Coderate von 4/5 Turbo unterstützt und als Reaktion auf das Durchführen der Turbcodierung an den PSDU-Daten unterschiedliche Codeblocklängen und unterschiedliche Coderaten gemäß unterschiedlichen Anforderungen ausgewählt werden,
wobei eine Anzahl von Bytes eines physischen Blocks in PB16 16 beträgt, eine Anzahl von Bytes eines physischen Blocks in PB40 40 beträgt, eine Anzahl von Bytes eines physischen Blocks in PB72 72 beträgt, eine Anzahl von Bytes eines physischen Blocks in PB136 136 beträgt, eine Anzahl von Bytes eines physischen Blocks in PB264 264 beträgt und eine Anzahl von Bytes eines physischen Blocks in PB520 520 beträgt.

4. Verfahren nach Anspruch 1, wobei sowohl die turbocodierten PHR-Daten als auch die turbocodierten PSDU-Daten als Reaktion auf das Durchführen des Kanal-Interleavings an turbocodierten PHR-Daten und turbocodierten PSDU-Daten in Informationscodes und Prüfcodes unterteilt werden, die separat einem Interleaving unterzogen werden, wobei Informationsbits der Informationscodes als Reaktion auf das Interleaving der Informationscodes in Spalten eingegeben und in Reihen ausgegeben werden und unterschiedliche Reihen derart ausgelesen werden, dass die Informationscodes ungeordnet sind, und die Prüfcodes in derselben Weise wie bei dem Interleaving der Informationscodes einem Interleaving unterzogen werden, außer dass die Prüfcodes von einer Offset-Adresse ausgelesen werden, und
einem Interleaving unterzogene Informationscodes und einem Interleaving unterzogene Prüfcodes dem Interleaving in einer Weise unterzogen werden, die gemäß einer Coderate bestimmt wird, die gemäß den Informationscodes und den Prüfcodes berechnet wird.

5. Verfahren nach Anspruch 1, ferner umfassend:
vor dem Durchführen (103) der inversen Fourier-Transformation an den SIG-Daten, in die die Pilotdaten eingefügt wurden, den PHR-Daten, in die die Pilotdaten eingefügt wurden, und den PSDU-Daten, in die die Pilotdaten eingefügt wurden, Durchführen einer Phasenrotation an den SIG-Daten, in die die Pilotdaten eingefügt wurden, den PHR-Daten, in die die Pilotdaten eingefügt wurden, und den PSDU-Daten, in die die Pilotdaten eingefügt wurden, wobei Referenzphasen für die Phasenrotation an SIG, PHR und PSDU verwendet werden und die Referenzphase π/4, multipliziert mit einem Phasenwinkelreferenzwert, der jedem Träger in 128 Trägern entspricht, ist.

6. Orthogonal-Frequency-Division-Multiplexing(OFDM)-basiertes System zur Erzeugung eines Physical-Layer-Übertragungssignals für eine drahtlose Hochgeschwindigkeitskommunikation, umfassend eine Datenempfangseinheit (1801), eine Datenverarbeitungseinheit (1802), eine Datenumwandlungseinheit (1803), eine OFDM-Symbolerzeugungseinheit (1804), eine Präambelsignaldatenerfassungseinheit (1805) und eine Einheit zur Erzeugung eines OFDM-basierten Framesignals (1806), wobei
die Datenempfangseinheit (1801) ausgelegt ist, um Ausgangsdaten von einem Medium-Access-Control(MAC)-Layer zu empfangen, Physical-Layer-Header(PHR)-Daten gemäß einem Modulations- und Codierungsschema von Physical-Layer-Service-Data-Unit(PSDU)-Daten in den Ausgangsdaten zu bestimmen und Signalfeld(SIG)-Daten gemäß einem Modulations- und Codierungsschema der PHR-Daten zu bestimmen,
die Datenverarbeitungseinheit (1802) ausgelegt ist, um jeweils die SIG-Daten, die PHR-Daten und die PSDU-Daten in einer jeweiligen vorgegebenen Verarbeitungsweise zu verarbeiten, um die verarbeiteten SIG-Daten, die verarbeiteten PHR-Daten und die verarbeiteten PSDU-Daten zu erlangen,
die Datenumwandlungseinheit (1803) ausgelegt ist, um ein Konstellationsmapping jeweils der verarbeiteten SIG-Daten, der verarbeiteten PHR-Daten und der verarbeiteten PSDU-Daten in einer jeweiligen vorgegebenen Mappingweise durchzuführen, leistungsgeregelte Pilotdaten jeweils in die verarbeiteten SIG-Daten, die verarbeiteten PHR-Daten und die verarbeiteten PSDU-Daten einzufügen sowie eine inverse Fourier-Transformation jeweils an den SIG-Daten, in die die Pilotdaten eingefügt wurden, den PHR-Daten, in die die Pilotdaten eingefügt wurden, und den PSDU-Daten, in die die Pilotdaten eingefügt wurden, zur Umwandlung in den Zeitbereich durchzuführen;
die OFDM-Symbolerzeugungseinheit (1804) ausgelegt ist, um einen zyklischen Präfix jeweils zu den in den Zeitbereich umgewandelten SIG-Daten, den in den Zeitbereich umgewandelten PHR-Daten und den in den Zeitbereich umgewandelten PSDU-Daten hinzuzufügen, um jeweils OFDM-Symbole, die den SIG-Daten entsprechen, OFDM-Symbole, die den PHR-Daten entsprechen, und OFDM-Symbole, die den PSDU-Daten entsprechen, zu erzeugen;
die Präambelsignaldatenerfassungseinheit (1805) ausgelegt ist, um eine inverse Fourier-Transformation und eine Leistungsregelung an in dem Frequenzbereich erzeugten Präambelsignaldaten durchzuführen, um Zeitbereichspräambelsignaldaten zu erlangen, und
die Einheit zur Erzeugung eines OFDM-basierten Framesignals (1806) ausgelegt ist,
um eine Fensterfunktion auf die Zeitbereichspräambelsignaldaten, die OFDM-Symbole, die den SIG-Daten entsprechen, die OFDM-Symbole, die den PHR-Daten entsprechen, und die OFDM-Symbole, die den PSDU-Daten entsprechen, anzuwenden, um ein OFDM-basiertes Framesignal zu erzeugen, das einem Analog-Front-End zugeführt wird,
wobei die Pilotdaten aus einer Pseudo-Noise(PN)-Sequenz erzeugt werden, wobei alle Anfangswerte 1 sind, wobei ein erstes Ausgangsbit der PN-Sequenz auf einem Pilotunterträger entsprechend Pilotton Nr. 1 in Satz 1 platziert wird, nachfolgende Bits sequenziell auf entsprechenden Pilotunterträgern platziert werden und die Pilotunterträger einheitlich eine Modulationsweise in Form einer binären Phasenumtastung, BPSK, verwenden,
wobei die OFDM-Symbole drei Optionen aufweisen, wobei eine schnelle Fourier-Transformation, FFT, in Option 1 128 Punkte aufweist, eine FFT in Option 2 64 Punkte aufweist, eine FFT in Option 3 32 Punkte aufweist und jedes OFDM-Symbol in einem SIG-Datenframe von einem Long-Training-Field(LTF)-Frame bis zu einem PSDU-Datenframe sequenziell einen Pilotsatz verwendet,
wobei das OFDM-basierte Framesignal die Präambelsignaldaten, die SIG-Daten, die PHR-Daten und die PSDU-Daten umfasst, wobei die Präambelsignaldaten Short-Training-Field(STF)-Daten und LTF-Daten umfassen,
wobei die STF-Daten durch ein Skalarprodukt von Sequenzen in einem Basis-Layer und einem Scrambling-Code-Layer erhalten werden, wobei der Scrambling-Code-Layer aus einer 10-Bit-Sequenz besteht, eine Sequenz in dem Scrambling-Code-Layer ungeachtet von OFDM-Optionen [-1 -1 -1-111 -1 -1-1 1] ist, eine STF-Sequenz vier STF-OFDM-Symbole aufweist und eine vor jedem OFDM-Symbol hinzugefügte Länge eines zyklischen Präfix 1/4 einer Länge des OFDM-Symbols ist, wobei es in Option 1 8 Sätze von wiederholten Daten innerhalb jedes Symbols mit einer FFT-Länge gibt, es in Option 2 4 Sätze von wiederholten Daten innerhalb jedes Symbols mit einer FFT-Länge gibt, und es in Option 3 2 Sätze von wiederholten Daten innerhalb jedes Symbols mit einer FFT-Länge gibt,
wobei die Datenverarbeitungseinheit (1802) ausgelegt ist, um jeweils die SIG-Daten, die PHR-Daten und die PSDU-Daten in einer jeweiligen vorgegebenen Verarbeitungsweise zu verarbeiten, um die verarbeiteten SIG-Daten, die verarbeiteten PHR-Daten und die verarbeiteten PSDU-Daten zu erlangen, und die Datenverarbeitungseinheit ein SIG-Datenverarbeitungsmodul, ein PHR-Datenverarbeitungsmodul und ein PSDU-Datenverarbeitungsmodul umfasst, wobei das SIG-Datenverarbeitungsmodul ausgelegt ist, um sequenziell eine Blockcodierung, eine Symbolfüllung und ein Scrambling an den SIG-Daten durchzuführen (36, 3), um die verarbeiteten SIG-Daten zu erlangen,
wobei das PHR-Datenverarbeitungsmodul ausgelegt ist, um sequenziell eine Turbocodierung, ein Kanal-Interleaving und eine Diversity-Kopie an den PHR-Daten durchzuführen, um die verarbeiteten PHR-Daten zu erlangen, und wobei das PSDU-Datenverarbeitungsmodul ausgelegt ist, um sequenziell ein Scrambling, eine Turbocdierung, ein Kanal-Interleaving und eine Diversity-Kopie an den PSDU-Daten durchzuführen, um die verarbeiteten PSDU-Daten zu erlangen,
wobei die Diversity-Kopie für Diversity und zum Mapping jeweils der PHR-Daten und der PSDU-Daten verwendet wird.

7. System nach Anspruch 6, wobei das PHR-Datenverarbeitungsmodul und das PSDU-Datenverarbeitungsmodul ferner ausgelegt sind, um:
die Turbocodierung jeweils an den PHR-Daten und den PSDU-Daten durch Verwenden eines Turbo-Encoders durchzuführen, wobei der Turbo-Encoder einen Turbo-Interleaver, einen ersten Komponenten-Encoder und einen zweiten Komponenten-Encoder umfasst, wobei jeweils ein Paar Informationsbits eingegeben wird und Systembits und Prüfbits ausgegeben werden, wobei die PHR-Daten und die PSDU-Daten jeweils als Eingabesignal des ersten Komponenten-Encoders und als Eingabesignal des Turbo-Interleavers verwendet werden und ein Ausgabesignal des Turbo-Interleavers als Eingabesignal des zweiten Komponentenencoders verwendet wird, wobei der Turbo-Interleaver ein Interleaving der PHR-Daten in Einheiten von Doppelbits durchführt, wobei eine Interleaving-Länge gleich einer Anzahl von Doppelbits ist, die in einer Blocklänge der PHR-Daten enthalten sind, und der Turbo-Interleaver ein Interleaving der PSDU-Daten in Einheiten von Doppelbits durchführt, wobei eine Interleaving-Länge gleich einer Anzahl von Doppelbits ist, die in einer Blocklänge der PSDU-Daten enthalten sind, und der Turbo-Interleaver unterschiedliche Coderaten gemäß unterschiedlichen Anforderungen auswählt.

8. System nach Anspruch 6, wobei ein Turbo-Codeblock als Reaktion auf das Durchführen der Turbocodierung an den PHR-Daten eine Länge eines physischen Blocks 16, PB16, aufweist und eine Coderate von 1/2 und eine Coderate von 4/5 unterstützt, und
wobei die PSDU-Daten sechs Modi unterstützen, bei denen es sich um PB16, PB40, PB72, PB136, PB264 und PB520 handelt, wobei jeder Modus eine Coderate von 1/2 und eine Coderate von 4/5 unterstützt und als Reaktion auf das Durchführen der Turbocodierung an den PSDU-Daten unterschiedliche Codeblocklängen und unterschiedliche Coderaten gemäß unterschiedlichen Anforderungen ausgewählt werden,
wobei eine Anzahl von Bytes eines physischen Blocks in PB16 16 beträgt, eine Anzahl von Bytes eines physischen Blocks in PB40 40 beträgt, eine Anzahl von Bytes eines physischen Blocks in PB72 72 beträgt, eine Anzahl von Bytes eines physischen Blocks in PB136 136 beträgt, eine Anzahl von Bytes eines physischen Blocks in PB264 264 beträgt und eine Anzahl von Bytes eines physischen Blocks in PB520 520 beträgt.

9. System nach Anspruch 6, wobei das PHR-Datenverarbeitungsmodul und das PSDU-Datenverarbeitungsmodul ferner ausgelegt sind, um:
jeweils die turbocodierten PHR-Daten und die turbocodierten PSDU-Daten als Reaktion auf das Durchführen des Kanal-Interleavings an turbocodierten PHR-Daten und turbocodierten PSDU-Daten in Informationscodes und Prüfcodes zu unterteilen, die separat einem Interleaving unterzogen werden, wobei Informationsbits der Informationscodes als Reaktion auf das Interleaving der Informationscodes in Spalten eingegeben und in Reihen ausgegeben werden und unterschiedliche Reihen derart ausgelesen werden, dass die Informationscodes ungeordnet sind, und die Prüfcodes in derselben Weise wie bei dem Interleaving der Informationscodes einem Interleaving unterzogen werden, außer dass die Prüfcodes von einer Offset-Adresse ausgelesen werden, und
einem Interleaving unterzogene Informationscodes und einem Interleaving unterzogene Prüfcodes einem Interleaving in einer Weise zu unterziehen, die gemäß einer Coderate bestimmt wird, die gemäß den Informationscodes und den Prüfcodes berechnet wird.

10. System nach Anspruch 6, wobei die Datenumwandlungseinheit (1803) ferner ausgelegt ist, um:
vor dem Durchführen der inversen Fourier-Transformation an den SIG-Daten, in die die Pilotdaten eingefügt wurden, den PHR-Daten, in die die Pilotdaten eingefügt wurden, und den PSDU-Daten, in die die Pilotdaten eingefügt wurden, eine Phasenrotation an den SIG-Daten, in die die Pilotdaten eingefügt wurden, den PHR-Daten, in die die Pilotdaten eingefügt wurden, und den PSDU-Daten, in die die Pilotdaten eingefügt wurden, durchzuführen, wobei Referenzphasen für die Phasenrotation an SIG, PHR und PSDU verwendet werden und die Referenzphase π/4, multipliziert mit einem Phasenwinkelreferenzwert, der jedem Träger in 128 Trägern entspricht, ist.

## Revendications

1. Procédé de génération de signal de transmission de couche physique de communication sans fil à grande vitesse sur la base d'un multiplexage par répartition orthogonale de la fréquence, MROF, comprenant :
la réception (101) de données de sortie provenant d'une couche de contrôle d'accès au support, MAC, la détermination (101) de données d'en-tête de couche physique, PHR, selon un schéma de modulation et de codage de données d'unité de données de service de couche physique, PSDU, dans les données de sortie, et la détermination (101) de données de champs de signal, SIG, selon un schéma de modulation et de codage des données PHR ;
le traitement (102) de chacune des données SIG, des données PHR et des données PSDU selon une manière de traitement prédéfinie respective afin d'acquérir les données SIG traitées, les données PHR traitées et les données PSDU traitées ;
la réalisation (103) d'une cartographie de constellation sur chacune des données SIG traitées, des données PHR traitées et des données PSDU traitées selon une manière de cartographie prédéfinie respective, l'insertion (103) de données pilotes commandées en puissance dans chacune des données SIG traitées, de données PHR traitées et de données PSDU traitées, et la réalisation (103) d'une transformée de Fourier inverse sur chacune des données SIG insérées avec les données pilotes, les données PHR insérées avec les données pilotes, et les données PSDU insérées avec les données pilotes pour une conversion dans le domaine temporel ;
l'ajout (104) d'un préfixe cyclique à chacune des données SIG converties dans le domaine temporel, des données PHR converties dans le domaine temporel, et des données PSDU converties dans le domaine temporel afin de générer des symboles MROF correspondant aux données SIG, des symboles MROF correspondant aux données PHR, et des symboles MROF correspondant aux données PSDU, respectivement ;
la réalisation (105) d'une transformée de Fourier inverse et d'une commande de puissance sur des données de signal de préambule générées dans le domaine fréquentiel afin d'acquérir des données de signal de préambule dans le domaine temporel ; et
le fenêtrage (106) des données de signal de préambule dans le domaine temporel, des symboles MROF correspondant aux données SIG, des symboles MROF correspondant aux données PHR, et des symboles MROF correspondant aux données PSDU afin de générer un signal de trame sur la base de MROF qui entre dans une extrémité avant analogique ;
dans lequel les données pilotes sont générées à partir d'une séquence de pseudo-bruit, PN, avec toutes les valeurs initiales égales à 1 ; un premier bit de sortie de la séquence PN est placé sur une sous-porteuse pilote correspondant à la tonalité pilote #1 dans l'ensemble 1, des bits suivants sont placés sur des sous-porteuses pilotes correspondantes en séquence, et des sous-porteuses pilotes utilisent uniformément une manière de modulation par déplacement de phase binaire, BPSK ;
les symboles MROF présentent trois options, dans lequel une transformation de Fourier rapide, FFT, en option 1, présente 128 points, une FFT en option 2 présente 64 points, une FFT en option 3 présente 32 points, et après une trame de champ d'entraînement long, LTF, chaque symbole MROF sur une trame de données SIG vers une trame de données PSDU utilise un ensemble pilote en séquence ;
le signal de trame sur la base de MROF comprend les données de signal de préambule, les données SIG, les données PHR et les données PSDU, dans lequel les données de signal de préambule comprennent des données de champ d'apprentissage court, STF, et des données LTF ;
les données STF sont obtenues par un produit scalaire de séquences dans une couche de base et une couche de code de brouillage, la couche de code de brouillage est composée d'une séquence de 10 bits, une séquence dans la couche de code de brouillage est [-1 -1 - 1-111 -1 -1-1 1] quelque soient les options MROF, une séquence STF présente quatre symboles MROF, et une longueur d'un préfixe cyclique ajouté avant chaque symbole MROF est égale à 1/4 de la longueur du symbole MROF, dans lequel, en option 1, il y a 8 ensembles de données répétées dans chaque symbole avec une longueur FFT, en option 2, il y a 4 ensembles de données répétées dans chaque symbole avec une longueur FFT et, en option 3, il y a 2 ensembles de données répétées dans chaque symbole avec une longueur FFT ;
dans lequel le traitement (102) de chacune des données SIG, des données PHR et des données PSDU de la manière de traitement prédéfinie respective afin d'acquérir les données SIG traitées, les données PHR traitées et les données PSDU traitées comprend :
la réalisation (36, 3) d'un codage de bloc, d'un remplissage de symbole et d'un brouillage sur les données SIG en séquence afin d'acquérir les données SIG traitées ;
la réalisation d'un codage Turbo, d'un entrelacement de canaux et d'une copie en diversité sur les données PHR en séquence afin d'acquérir les données PHR traitées, dans lequel la copie en diversité est utilisée pour la diversité et la cartographie sur les données PHR ; et
la réalisation d'un brouillage, d'un codage Turbo, d'un entrelacement de canaux et d'une copie en diversité sur les données PSDU en séquence afin d'acquérir les données PSDU traitées, dans lequel la copie en diversité est utilisée pour la diversité et la cartographie sur les données PSDU.

2. Procédé selon la revendication 1, dans lequel le codage Turbo est réalisé sur chacune des données PHR et des données PSDU à l'aide d'un codeur Turbo, dans lequel le codeur Turbo comprend un entrelaceur Turbo, un codeur de première composante et un codeur de deuxième composante, dans lequel à chaque fois qu'une paire de bits d'informations est entrée, des bits système et des bits de contrôle sont délivrés en sortie ; les données PHR et les données PSDU sont chacune utilisées en tant que signal d'entrée du codeur de première composante et signal d'entrée de l'entrelaceur Turbo, et un signal de sortie de l'entrelaceur Turbo est utilisé en tant que signal d'entrée du codeur de deuxième composante ; l'entrelaceur Turbo entrelace les données PHR en unités de bits doubles, et une longueur d'entrelacement est égale à un nombre de bits doubles compris dans une longueur de bloc des données PHR ; l'entrelaceur Turbo entrelace les données PSDU en unités de bits doubles, et une longueur d'entrelacement est égale à un nombre de bits doubles compris dans une longueur de bloc des données PSDU ; et l'entrelaceur Turbo sélectionne des débits de code différents en fonction d'exigences différentes.

3. Procédé selon la revendication 1, dans lequel, en réponse à la réalisation du codage Turbo sur les données PHR, un bloc de code Turbo présente une longueur de bloc physique 16, PB16 et prend en charge un débit de code de 1/2 et un débit de code de 4/5 ; et
les données PSDU prennent en charge six modes, qui sont PB16, PB40, PB72, PB136, PB264 et PB520, chaque mode prend en charge un débit de code de 1/2 et un débit de code de 4/5, et, en réponse à la réalisation du codage Turbo sur les données PSDU, des longueurs de bloc de code différentes et des débits de code différents sont sélectionnés en fonction d'exigences différentes ;
dans lequel un nombre d'octets d'un bloc physique dans PB16 est 16, un nombre d'octets d'un bloc physique dans PB40 est 40, un nombre d'octets d'un bloc physique dans PB72 est 72, un nombre d'octets d'un bloc physique dans PB136 est 136, un nombre d'octets d'un bloc physique dans PB264 est 264, et un nombre d'octets d'un bloc physique dans PB520 est 520.

4. Procédé selon la revendication 1, dans lequel, en réponse à la réalisation de l'entrelacement de canaux sur les données PHR Turbo-codées et les données PSDU Turbo-codées, chacune des données PHR Turbo-codées et des données PSDU Turbo-codées est divisée en codes d'informations et codes de contrôle qui sont entrelacés séparément ; dans lequel, en réponse à l'entrelacement des codes d'informations, des bits d'informations des codes d'informations sont entrés en colonnes et délivrés en sortie en rangées, et des rangées différentes sont lues de telle sorte que les codes d'informations sont décomposés ; et les codes de contrôle sont entrelacés de la même manière que l'entrelacement des codes d'informations sauf que les codes de contrôle sont lus à partir d'une adresse de décalage ; et
les codes d'informations entrelacés et les codes de contrôle entrelacés sont entrelacés d'une manière déterminée en fonction d'un débit de code qui est calculé en fonction des codes d'informations et des codes de contrôle.

5. Procédé selon la revendication 1, comprenant en outre :
avant la réalisation (103) de la transformée de Fourier inverse sur les données SIG insérées avec les données pilotes, les données PHR insérées avec les données pilotes, et les données PSDU insérées avec les données pilotes, la réalisation d'une rotation de phase sur les données SIG insérées avec les données pilotes, les données PHR insérées avec les données pilotes, et les données PSDU insérées avec les données pilotes, dans lequel les phases de référence sont utilisées pour la rotation de phase sur les données SIG, PHR, et PSDU, la phase de référence est de π/4 multipliée par une valeur de référence d'angle de phase correspondant à chaque porteuse parmi 128 porteuses.

6. Système de génération de signal de transmission de couche physique de communication sans fil à grande vitesse sur la base d'un multiplexage par répartition orthogonale de la fréquence, MROF, comprenant une unité de réception de données (1801), une unité de traitement de données (1802), une unité de conversion de données (1803), une unité de génération de symboles MROF (1804), une unité d'acquisition de données de signal de préambule (1805) et une unité de génération de signal de trame sur la base de MROF (1806) ; dans lequel
l'unité de réception de données (1801) est configurée pour recevoir des données de sortie provenant d'une couche de contrôle d'accès au support, MAC, déterminer des données d'en-tête de couche physique, PHR, selon un schéma de modulation et de codage de données d'unité de données de service de couche physique, PSDU, dans les données de sortie, et déterminer des données de champs de signal, SIG, selon un schéma de modulation et de codage des données PHR ;
l'unité de traitement de données (1802) est configurée pour traiter chacune des données SIG, des données PHR et des données PSDU selon une manière de traitement prédéfinie respective afin d'acquérir les données SIG traitées, les données PHR traitées et les données PSDU traitées ;
l'unité de conversion de données (1803) est configurée pour réaliser une cartographie de constellation sur chacune des données SIG traitées, des données PHR traitées et des données PSDU traitées selon une manière de cartographie prédéfinie respective, insérer des données pilotes commandées en puissance dans chacune des données SIG traitées, des données PHR traitées et des données PSDU traitées, et réaliser une transformée de Fourier inverse sur chacune des données SIG insérées avec les données pilotes, les données PHR insérées avec les données pilotes, et les données PSDU insérées avec les données pilotes pour une conversion dans le domaine temporel ;
l'unité de génération de symboles MROF (1804) est configurée pour ajouter un préfixe cyclique à chacune des données SIG converties dans le domaine temporel, des données PHR converties dans le domaine temporel, et des données PSDU converties dans le domaine temporel afin de générer des symboles MROF correspondant aux données SIG, des symboles MROF correspondant aux données PHR, et des symboles MROF correspondant aux données PSDU, respectivement ;
l'unité d'acquisition de données de signal de préambule (1805) est configurée pour réaliser une transformée de Fourier inverse et une commande de puissance sur des données de signal de préambule générées dans le domaine fréquentiel afin d'acquérir des données de signal de préambule dans le domaine temporel ; et
l'unité de génération de signal de trame sur la base de MROF (1806) est configurée pour fenêtrer les données de signal de préambule dans le domaine temporel, les symboles MROF correspondant aux données SIG, les symboles MROF correspondant aux données PHR, et les symboles MROF correspondant aux données PSDU afin de générer un signal de trame sur la base de MROF qui entre dans une extrémité avant analogique ;
dans lequel les données pilotes sont générées à partir d'une séquence de pseudo-bruit, PN, avec toutes les valeurs initiales égales à 1 ; un premier bit de sortie de la séquence PN est placé sur une sous-porteuse pilote correspondant à la tonalité pilote #1 dans l'ensemble 1, des bits suivants sont placés sur des sous-porteuses pilotes correspondantes en séquence, et des sous-porteuses pilotes utilisent uniformément une manière de modulation par déplacement de phase binaire, BPSK ;
les symboles MROF présentent trois options, dans lequel une transformation de Fourier rapide, FFT, en option 1, présente 128 points, une FFT en option 2 présente 64 points, une FFT en option 3 présente 32 points, et après une trame de champ d'entraînement long, LTF, chaque symbole MROF sur une trame de données SIG vers une trame de données PSDU utilise un ensemble pilote en séquence ;
le signal de trame sur la base de MROF comprend les données de signal de préambule, les données SIG, les données PHR et les données PSDU, dans lequel les données de signal de préambule comprennent des données de champ d'apprentissage court, STF, et des données LTF ;
les données STF sont obtenues par un produit scalaire de séquences dans une couche de base et une couche de code de brouillage, la couche de code de brouillage est composée d'une séquence de 10 bits, une séquence dans la couche de code de brouillage est [-1 -1 - 1-111 -1 -1-1 1] quelque soient les options MROF, une séquence STF présente quatre symboles MROF, et une longueur d'un préfixe cyclique ajouté avant chaque symbole MROF est égale à 1/4 de la longueur du symbole MROF, dans lequel, en option 1, il y a 8 ensembles de données répétées dans chaque symbole avec une longueur FFT, en option 2, il y a 4 ensembles de données répétées dans chaque symbole avec une longueur FFT et, en option 3, il y a 2 ensembles de données répétées dans chaque symbole avec une longueur FFT ;
dans lequel l'unité de traitement de données (1802) est configurée pour traiter chacune des données SIG, des données PHR et des données PSDU de la manière de traitement prédéfinie respective afin d'acquérir les données SIG traitées, les données PHR traitées et les données PSDU traitées, et l'unité de traitement de données comprend un module de traitement de données SIG, un module de traitement de données PHR et un module de traitement de données PSDU ; dans lequel le module de traitement de données SIG est configuré pour réaliser (36, 3) un codage de bloc, un remplissage de symbole et un brouillage sur les données SIG en séquence afin d'acquérir les données SIG traitées ;
le module de traitement de données PHR est configuré pour réaliser un codage Turbo, un entrelacement de canaux et une copie en diversité sur les données PHR en séquence afin d'acquérir les données PHR traitées ; et le module de traitement de données PSDU est configuré pour réaliser un brouillage, un codage Turbo, un entrelacement de canaux et une copie en diversité sur les données PSDU en séquence afin d'acquérir les données PSDU traitées ;
dans lequel la copie en diversité est utilisée pour la diversité et la cartographie sur chacune des données PHR et des données PSDU.

7. Système selon la revendication 6, dans lequel le module de traitement de données PHR et le module de traitement de données PSDU sont en outre configurés pour :
réaliser le codage Turbo sur chacune des données PHR et des données PSDU respectivement à l'aide d'un codeur Turbo, dans lequel le codeur Turbo comprend un entrelaceur Turbo, un codeur de première composante et un codeur de deuxième composante, dans lequel à chaque fois qu'une paire de bits d'informations est entrée, des bits système et des bits de contrôle sont délivrés en sortie ; les données PHR et les données PSDU sont chacune utilisées en tant que signal d'entrée du codeur de première composante et signal d'entrée de l'entrelaceur Turbo, et un signal de sortie de l'entrelaceur Turbo est utilisé en tant que signal d'entrée du codeur de deuxième composante ; l'entrelaceur Turbo entrelace les données PHR en unités de bits doubles, dans lequel une longueur d'entrelacement est égale à un nombre de bits doubles compris dans une longueur de bloc des données PHR, et l'entrelaceur Turbo entrelace les données PSDU en unités de bits doubles, dans lequel une longueur d'entrelacement est égale à un nombre de bits doubles compris dans une longueur de bloc des données PSDU ; et l'entrelaceur Turbo sélectionne des débits de code différents en fonction d'exigences différentes.

8. Système selon la revendication 6, dans lequel, en réponse à la réalisation du codage Turbo sur les données PHR, un bloc de code Turbo présente une longueur de bloc physique 16, PB16 et prend en charge un débit de code de 1/2 et un débit de code de 4/5 ; et
les données PSDU prennent en charge six modes, qui sont PB16, PB40, PB72, PB136, PB264 et PB520, chaque mode prend en charge un débit de code de 1/2 et un débit de code de 4/5, et, en réponse à la réalisation du codage Turbo sur les données PSDU, des longueurs de bloc de code différentes et des débits de code différents sont sélectionnés en fonction d'exigences différentes ;
dans lequel un nombre d'octets d'un bloc physique dans PB16 est 16, un nombre d'octets d'un bloc physique dans PB40 est 40, un nombre d'octets d'un bloc physique dans PB72 est 72, un nombre d'octets d'un bloc physique dans PB136 est 136, un nombre d'octets d'un bloc physique dans PB264 est 264, et un nombre d'octets d'un bloc physique dans PB520 est 520.

9. Système selon la revendication 6, dans lequel le module de traitement de données PHR et le module de traitement de données PSDU sont en outre configurés pour :
en réponse à la réalisation de l'entrelacement de canaux sur les données PHR Turbo-codées et les données PSDU Turbo-codées, chacune des données PHR Turbo-codées et des données PSDU Turbo-codées est divisée en codes d'informations et codes de contrôle qui sont entrelacés séparément ; dans lequel, en réponse à l'entrelacement des codes d'informations, des bits d'informations des codes d'informations sont entrés en colonnes et délivrés en sortie en rangées, et des rangées différentes sont lues de telle sorte que les codes d'informations sont décomposés ; et les codes de contrôle sont entrelacés de la même manière que l'entrelacement des codes d'informations sauf que les codes de contrôle sont lus à partir d'une adresse de décalage ; et
les codes d'informations entrelacés et les codes de contrôle entrelacés sont entrelacés d'une manière déterminée en fonction d'un débit de code qui est calculé en fonction des codes d'informations et des codes de contrôle.

10. Système selon la revendication 6, dans lequel l'unité de conversion de données (1803) est en outre configurée pour :
avant de réaliser la transformée de Fourier inverse sur les données SIG insérées avec les données pilotes, les données PHR insérées avec les données pilotes, et les données PSDU insérées avec les données pilotes, réaliser une rotation de phase sur les données SIG insérées avec les données pilotes, les données PHR insérées avec les données pilotes, et les données PSDU insérées avec les données pilotes, dans lequel les phases de référence sont utilisées pour la rotation de phase sur les données SIG, les PHR, et les PSDU, la phase de référence est de π/4 multipliée par une valeur de référence d'angle de phase correspondant à chaque porteuse parmi 128 porteuses.
